# EUROPEAN PATENT APPLICATION

(11) **EP 4 184 586 A1**
(43) Date of publication of application: **24.05.2023**
(21) Application number: 22199552.5
(22) Date of filing: 04.10.2022
(51) Int. Cl.: H01L 29/06, H01L 29/08, H01L 21/336, H01L 29/775, H01L 29/78, B82Y 10/00, H01L 29/32

(54) **GATE-ALL-AROUND TRANSISTOR DEVICE WITH COMPRESSIVELY STRAINED CHANNEL LAYERS**

(30) Priority: 19.11.2021 US 202117531154
(71) Applicant: INTEL Corporation, Santa Clara, CA 95054 (US)
(72) Inventor: BOMBERGER, Cory, Portland, 97225 (US); MURTHY, Anand, Portland, 97229 (US); SHAH, Rushabh, Hillsboro, 97124 (US); NASKAR, Sudipto, Portland, 97229 (US)
(74) Representative: Goddar, Heinz J.

(57) **Abstract**

An integrated circuit (IC) device (800B, 800C), and a method of forming the same. The IC device includes a transistor device comprising a multilayer stack that has a plurality of channel layers (Si channel) including a semiconductor material; a gate structure wrapped at least partially around the channel layers, the gate structure including a metal; an epitaxial source structure (112B) at a first lateral end of the multilayer stack; an epitaxial drain structure (112B) at a second lateral end of the multilayer stack opposite the first lateral end; and inner spacers (120B, 120C) between the gate structure and respective ones of the source structure and the drain structure, wherein the epitaxial source and drain structures are formed prior to removing the sacrificial semiconductor layers and forming the inner spacers, because of which the source and drain structures do not exhibit crystallographic defects extending from the inner spacers. The source drain structures furthermore exert compressive strain on the channel layers.

## Description

### Technical Field

This disclosure relates generally to gate-all-around (GAA) transistor device structures, and to methods of forming the same.

### Background

The current processing for gate-all-around (GAA) transistor devices results in positive epitaxial (p-EPI) source/drain deposition occurring from multiple discontinuous growth surfaces resulting in defects in the EPI when the growth fronts merge and ultimately resulting in no compressive strain or even tensile strain in the channel. These discontinuous growth fronts occur during processing, where a spacer material is present between the channel layers during the source/drain deposition. The selective growth of p-EPI deposition results in multiple growth fronts merging during growth, resulting in defects.

### Brief Description of the Drawings

The embodiments of the disclosure will be understood more fully from the detailed description given below and from the accompanying drawings of various embodiments of the disclosure, which, however, should not be taken to limit the disclosure to the specific embodiments, but are for explanation and understanding only.
Fig. 1 illustrates a cross-sectional view of a multilayer stack on s substrate or subfin, the stack including channel layers interposed between sacrificial layers.
Fig. 2 illustrates a cross-sectional view showing the structure of Fig. 1 after replacement gate structures have been disposed thereon.
Fig. 3 illustrates a cross-sectional view showing the structure of Fig. 2 after a source/drain etch.
Fig. 4A illustrates a cross-sectional view showing the structure of Fig. 3 after a cavity etch according to the state of the art.
Fig. 4B illustrates a cross-sectional view showing the structure of Fig. 3 and provided for the sake of side-by-side comparison with Fig. 4A.
Fig. 5A illustrates a cross-sectional view showing the structure of Fig. 4A after provision of inner spacers inside the cavities according to the state of the art.
Fig. 5B illustrates a cross-sectional view showing the structure of Fig. 3 or Fig. 4B and provided for the sake of side-by-side comparison with Fig. 5A.
Fig. 6A illustrates a cross-sectional view showing the structure of Fig. 5A after provision of a source/drain region and of an interlayer dielectric (ILD) on the source/drain region according to the state of the art.
Fig. 6B illustrates a cross-sectional view showing the structure of Fig. 5B after provision of a source/drain region and of an interlayer dielectric (ILD) on the source/drain region according to an example embodiment.
Fig. 7A illustrates a cross-sectional view showing the structure of Fig. 6A after removal of the sacrificial layers within the stack, and after removal of the replacement gates according to the state of the art.
Fig. 7B illustrates a cross-sectional view showing the structure of Fig. 6B after removal of the sacrificial layers within the stack, and after removal of the replacement gates according to an example embodiment.
Fig. 8A illustrates a cross-sectional view showing the structure of Fig. 7A, and provided for the sake of side-by-side comparison with Figs. 8B and 8C.
Fig. 8B illustrates a cross-sectional view showing the structure of Fig. 7B after provision of inner spacers according to a first embodiment.
Fig. 8C illustrates a cross-sectional view showing the structure of Fig. 7B after provision of inner spacers according to a second embodiment.
Fig. 9A illustrates a cross-sectional view showing the structure of Fig. 8A, and after provision of a gate structure according to the state of the art.
Fig. 9B illustrates a cross-sectional view showing the structure of Fig. 8B, and after provision of a gate structure according to a first embodiment.
Fig. 9C illustrates a cross-sectional view showing the structure of Fig. 8C, and after provision of a gate structure according to a first embodiment.
Fig. 10A is a flow chart of a process according to the state of the art.
Fig. 10B is a flow chart of a process according to some embodiments.
Fig. 11 is a cross-sectional side view of an integrated circuit device assembly that may include a cascaded ESOL circuit, in accordance with any of the embodiments disclosed herein.
Fig. 12 is a block diagram of an example electrical device that may include a transistor device, in accordance with any of the embodiments disclosed herein.
Fig. 13 is a flow chart of a process according to some embodiments.

### Description of Embodiments

Semiconductor devices are electronic components that exploit the electronic properties of semiconductor materials, such as silicon (Si), germanium (Ge), silicon germanium (SiGe) and gallium arsenide (GaAs). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel or n-type device, and in instances where the charge carriers are holes, the FET is referred to as a p-channel or p-type device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (pMOS) and n-channel MOSFET (nMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations essentially resides along the three different outer regions of the fin (e.g., top and two sides), such a FinFET design is sometimes referred to as a tri-gate transistor. Other types of FinFET configurations are also available, such as socalled double-gate FinFETs, in which the conductive channel principally resides only along the two sidewalls of the fin (and not along the top of the fin). A gate-all-around (GAA) transistor is configured similarly to a fin-based transistor, but instead of a finned channel region where the gate is on three portions (and thus, there are three effective gates), the gate material generally wraps around each nanowire, nanoribbon, or nanosheet included in the channel region of the GAA transistor device.

Some embodiments provide a method to fabricate an integrated circuit (IC) device for example including a GAA transistor device, where a source/drain deposition is made within a trench through the channel layers and sacrificial layers of a channel stack without the presence of inner spacers. The inner spacer deposition is performed after provision of the source/drain structures. In this manner, an IC device is provided where an integrated average of strains in the channel layers exhibits a total compressive strain in the channel layers, and where the source/drain structures are substantially free of crystallographic defects. In particular, at least some source/drain structures of an IC device such as one including one or more GAA transistors according to embodiments do not exhibit a pattern of crystallographic defects extending from inner spacer regions adjacent the metal gate.

Current solutions rely achieving channel strain (or minimizing tensile strain) in channels of positive MOS (pMOS) transistors via isolation structures on the wafer between sets of pMOS transistors. Relying on isolation structures to provide channel strain however can provide only a minimal amount of compressive strain compared to the strain possible from a defect free epitaxial structure. Additionally, as the number channels increase in each set of pMOS transistors, the amount of strain that an isolation structure can provide decreases, as there are more pMOS channels to be subjected to compressive strain between a same pair of isolation structures.

Some embodiments advantageously enable the p-EPI source/drain structures on a GAA transistor device to provide compressive channel strain, which helps to increase channel mobility, and ultimately the drive of the pMOS transistors in the same way as p-EPI source/drain structures in FinFET transistor devices.

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims. In the following description, various aspects of the illustrative implementations will be described using terms commonly employed by those skilled in the art to convey the substance of their work to others skilled in the art. However, it will be apparent to those skilled in the art that embodiments of the present disclosure may be practiced with only some of the described aspects. For purposes of explanation, specific numbers, materials, and configurations are set forth in order to provide a thorough understanding of the illustrative implementations. However, it will be apparent to one skilled in the art that embodiments of the present disclosure may be practiced without the specific details. In other instances, well-known features are omitted or simplified in order not to obscure the illustrative implementations.

In the following detailed description, reference is made to the accompanying drawings that form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

A multitude of different transistor devices can benefit from the techniques described herein, which includes, but is not limited to, various field-effect transistors (FETs), such as metal-oxide-semiconductor FETs (MOSFETs).

As described herein, in a source-channel-drain doping scheme of n-p-n or n-in, "n: indicates n-type doped semiconductor material, "p" indicates p-type doped semiconductor material.

The techniques described herein may be used to benefit a p-channel MOSFET (pMOS) device, which may include a source-channel-drain doping scheme of p-n-p or p-i-p, in accordance with some embodiments.

Although the techniques are depicted and described herein for gate-all-around (GAA) device configurations (e.g., employing one or more nanowires or nanoribbons), the techniques could be used for other device configurations, such as finned transistor configurations or FinFET configurations, for example. Further, the techniques are used in some embodiments to benefit complementary transistor circuits, such as complementary MOS (CMOS) circuits, where the techniques may be used to benefit one or more of the included p-channel transistors making up the CMOS circuit.

Further still, any such devices may employ semiconductor materials that are three-dimensional crystals as well as two dimensional crystals or nanotubes, for example. In some embodiments, the techniques may be used to benefit devices of varying scales, such as IC devices having critical dimensions in the micrometer (micron) range and/or in the nanometer (nm) range (e.g., formed at the 22, 14, 10, 7, 5, or 3 nm process nodes, or beyond).

As described herein, deposition or epitaxial growth techniques (or more generally, additive processing) may use any suitable techniques, such as chemical vapor deposition (CVD), physical vapor deposition (PVD), atomic layer deposition (ALD), and/or molecular beam epitaxy (MBE), to provide some examples.

As described herein, etching techniques (or more generally, subtractive processing) can use any suitable techniques, such as wet and/or dry etch processing which may be isotropic (e.g., uniform etch rate in all directions) or anisotropic (e.g., etch rates that are orientation dependent), and which may be non-selective (e.g., etches all exposed materials at the same or similar rates) or selective (e.g., etches different materials that are exposed at different rates). Further note that other processing may be used to form the and integrated circuit structures described herein, as will be apparent in light of this disclosure, such as hardmasking, patterning or lithography (via suitable lithography techniques, such as, e.g., photolithography, extreme ultraviolet lithography, x-ray lithography, or electron beam lithography), planarizing or polishing (e.g., via chemical-mechanical planarization (CMP) processing), doping (e.g., via ion implantation, diffusion, or including dopant in the base material during formation), and annealing, to name some examples.

In embodiments where semiconductor material described herein includes dopant, the dopant is any suitable n-type and/or p-type dopant that is known to be used for the specific semiconductor material. For instance, in the case of group IV semiconductor materials (e.g., Si, SiGe, Ge), p-type dopant includes group III atoms (e.g., boron, gallium, aluminum), and n-type dopant includes group V atoms (e.g., phosphorous, arsenic, antimony). In the case of group III-V semiconductor materials (e.g., GaAs, InGaAs, InP, GaP), p-type dopant includes group II atoms (e.g., beryllium, zinc, cadmium), and n-type dopant includes group VI atoms (e.g., selenium, tellurium). However, for group III-V semiconductor materials, group VI atoms (e.g., silicon, germanium) can be employed for either p-type or n-type dopant, depending on the conditions (e.g., formation temperatures).

In embodiments where dopant is included in semiconductor material, the dopant can be included at quantities in the range of 1¹⁶ to 1²² atoms per cubic cm, or higher, for example, unless otherwise stated. In some embodiments, dopant is included in semiconductor material in a quantity of at least 1¹⁶, 1¹⁷, 1¹⁸, 5¹⁸, 1¹⁹, 5¹⁹, 1²⁰, 5²⁰, or 1²¹ atoms per cubic cm and/or of at most 1²², 5²¹, 1²¹, 5²⁰, 1²⁰, 5¹⁹, 1¹⁹, 5¹⁸, or 1¹⁸ atoms per cubic cm, for example. In some embodiments, semiconductor material described herein is undoped/intrinsic, or includes relatively minimal dopant, such as a dopant concentration of less than 1¹⁶ atoms per cubic cm, for example.

The use of "group IV semiconductor material" (or "group IV material" or generally, "IV") herein includes at least one group IV element (e.g., silicon, germanium, carbon, tin), such as silicon (Si), germanium (Ge), silicon germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), and so forth. Also note that group III may also be known as the boron group or IUPAC group 13, group IV may also be known as the carbon group or IUPAC group 14, and group V may also be known as the nitrogen group or IUPAC group 15, for example. Further note that semiconductor material described herein has a monocrystalline or single-crystal structure (also referred to as a crystalline structure) unless otherwise explicitly stated (e.g., unless referred to as having a polycrystalline or amorphous structure).

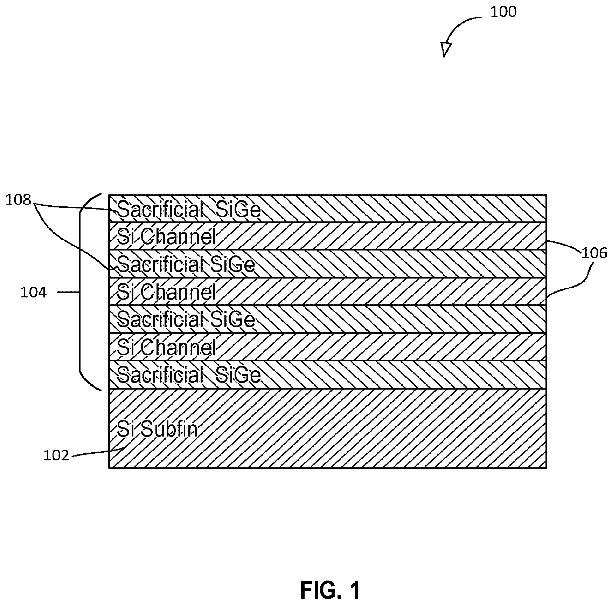

Reference will now be made to a comparative flow to fabricate a GAA transistor device according to the state of the art and an example embodiment. In Figs. 1-9 described below, figures with no "A" or "B" designation are meant to apply to both state of the art and innovative flows, figures with an "A" designation refer to the state of the art flow, and figures with a "B" designation refer to an example innovative flow according to some embodiments.

Referring To Fig. 1, a first operation includes providing a structure 100 including subfin, such as a silicon subfin 102, and blanket SiGe/Si superlattice stack deposition to provide the superlattice or multilayer stack 104 including bilayers of silicon nanowires or channels 106 and sacrificial layers 108 including, for example, SiGe. The subfin may include a material including, for example: a bulk substrate including group IV semiconductor material (such as Si, Ge, or SiGe), group III-V semiconductor material, and/or any other suitable material as can be understood based on this disclosure; an X on insulator (XOI) structure where X is one of the aforementioned semiconductor materials and the insulator material is an oxide material or dielectric material, such that the XOI structure includes the electrically insulating material layer between two semiconductor layers (e.g., a silicon-on-insulator (SOI) structure); or some other suitable multilayer structure where the top layer includes semiconductor material from which the materials of multilayer stack 104 can be formed.

In some embodiments, material of subfin 102 includes a surface crystalline orientation described by a Miller index of (100), (110), or (111), or its equivalents. Although subfin 102 is shown in the figures as having a thickness (dimension in the Y-axis direction) similar to other layers for ease of illustration, in some instances, subfin 102 may be relatively much thicker than the other layers, such as having a thickness in the range of 1 to 950 microns (or in the sub-range of 20 to 800 microns), for example, or any other suitable thickness value or range as can be understood based on this disclosure. In some embodiments, subfin 102 includes a multilayer structure including two or more distinct layers (that may or may not be compositionally different). In some embodiments, subfin 102 includes grading (e.g., increasing and/or decreasing) of one or more material concentrations throughout at least a portion of the subfin 102. In some embodiments, subfin 102 is used for one or more other IC devices, such as various diodes (e.g., light-emitting diodes (LEDs) or laser diodes), various transistors (e.g., MOSFETs, TFETs), various capacitors (e.g., MOSCAPs), various microelectromechanical systems (MEMS), various nanoelectromechanical systems (NEMS), various radio frequency (RF) devices, various sensors, and/or any other suitable semiconductor or IC devices, depending on the end use or target application. Accordingly, in some embodiments, the structures described herein are included in system-on-chip (SoC) applications.

In some embodiments, optional substrate modifications occur to for sub-fin isolation purposes. For instance, in some such embodiments, a top portion of the subfin 102 is doped and/or a doped semiconductor layer is formed on the top surface of the substrate, where the dopant included in and/or on the top of the subfin 102 is opposite in type relative to the eventual final source/drain material. For example, for a final source/drain material including p-type dopant for a pMOS GAA transistor device, the substrate modification may include forming n-type doped semiconductor material. The processing can include doping the top surface of subfin 102 and/or forming at least one layer of doped semiconductor material on subfin 102 prior to forming multilayer stack 104

Forming the multilayer stack 104 on subfin 102 includes providing the one or more channel layers 106 and one or more sacrificial layers 108, in accordance with some embodiments, and patterning it into a fin shape as seen in a cross section taken in plane perpendicular to the plane of Fig. 1. As can be understood based on this disclosure, the multilayer stack 104, which includes sacrificial layers 108 and channel layers 106 in Fig. 1, is to be used to form one or more GAA transistor devices, where the one or more channel layers 106 are to be released from the one or more sacrificial layers 108 via selective etch processing to enable forming the gate structure of each device around the released channel layers 106. Each of those channel layers 106 may be referred to herein as a body, and each channel layer 106 may be considered a nanowire, nanoribbon, or nanosheet, as can also be understood based on this disclosure.

In some embodiments, layers 108 and 106 in the fin-shaped multilayer stack 104 can be formed using any suitable techniques as can be understood based on this disclosure. For instance, in some embodiments, the layers 108 and 106 are blanket deposited on substrate 102, patterned into fins, and then shallow trench isolation (STI) processing can be performed to form isolation or STI.

In other embodiments, a replacement fin processing scheme is employed, where the top portion of substrate 102 is formed into fins, STI material is formed in the trenches between the fins (not shown), the fins are recessed to form trenches between STI regions, layers 108 and 106 are deposited in the STI region trenches, and then the STI material is recessed to expose the fin-shaped multilayer stack. Although there is only one fin-shaped multilayer stack 104 shown in, multiple different multilayer stacks and lines may be processed simultaneously to form hundreds, thousands, millions, or even billions of devices on an individual integrated circuit substrate, as can be understood based on this disclosure.

Multilayer stack 104, in some embodiments, includes one or more sacrificial layers 108 and one or more channel layers 106. The layers 108 and 106 in multilayer stack 104 alternate, where the first and last layer in the multilayer stack 104 is a sacrificial layer 108. Specifically, the multilayer stack 104 includes four sacrificial layers 108 and three channel layers 106, as shown. However, in other embodiments, any number of sacrificial layers 108 and channel layers 106 may be employed, such as 1-10 or more of each. In addition, in some embodiments, the same number of sacrificial layers 108 and channel layers 106 are included in the multilayer stack 104.

Sacrificial layers 108 and channel layers 106, in some embodiments, include semiconductor material. In some embodiments, the layers 108 and 106 include group IV and/or group III-V semiconductor material. Thus, in some embodiments, layers 108 and 106 include one or more of germanium, silicon, tin, indium, gallium, aluminum, arsenic, phosphorous, antimony, bismuth, or nitrogen. In some embodiments, the semiconductor material included in one or both of layers 108 and/or 106 also includes dopant (n-type and/or p-type dopant), while in other embodiments, the semiconductor material is undoped/intrinsic. In some embodiments, the semiconductor material included in sacrificial layer 108 can be selectively removed relative to the semiconductor material included in channel layers 106 via selective etch processing. Such selective etch processing allows the sacrificial layers 108 to be removed during the replacement gate processing to release the channel layers 106.

Thus, in some embodiments, sacrificial layer 108 and channel layers include compositionally different material, which provides the etch selectivity described herein between the two materials. Materials that are "compositionally different" or "compositionally distinct" as used herein refers to two materials that have different chemical compositions. This compositional difference may be, for instance, by virtue of an element that is in one material but not the other (e.g., silicon germanium is compositionally different from silicon), or by way of one material having all the same elements as a second material but at least one of those elements is intentionally provided at a different concentration in one material relative to the other material (e.g., SiGe having 70 atomic percent germanium is compositionally different from SiGe having 25 atomic percent germanium). In addition to such chemical composition diversity, the materials may also have distinct dopants (e.g., boron versus arsenic/phosphorous) or the same dopants but at differing concentrations. In still other embodiments, compositionally different materials may further refer to two materials that have different crystallographic orientations. For instance, (110) Si is compositionally distinct or different from (100) Si.

In some embodiments, both of layers 108 and layers 106 include group IV semiconductor material. For instance, in some such embodiments, one of layers 108 or layers 106 includes Si, and the other of layers 108 or layers 106 includes SiGe or Ge (e.g., sacrificial layers 108 include Si and channel layers include Ge). Further, in some embodiments, one of layers 108 or layers 106 includes SiGe, and the other of layers 108 or layers 106 includes Si, Ge, or SiGe. Further still, in some embodiments, one of layers 108 or layers 106 includes Ge, and the other of layers 108 or layers 106 includes Si or SiGe. Regardless, in any such embodiments where both of layers 108 and 106 include group IV semiconductor material, the Ge concentration included in layers 108 and 106 may be relatively different by at least 20, 25, 30, 35, or 40 atomic percent to ensure etch selectivity can be achieved, for example. In some embodiments, both of layers 108 and 106 include group III-V semiconductor material. For instance, in some such embodiments, one of layers 108 or layers 106 includes GaAs, and the other of layers 108 or layers 106 includes InGaAs or InP. Further in some embodiments, one of layers 108 or layers 106 includes InGaAs, and the other of layers 108 or layers 106 includes GaAs, InP, or InGaAs (e.g., with a different In:Ga ratio). Further still, in some embodiments, one of layers 108 or layers 106 includes InP, and the other of layers 108 or 106 includes GaAs or InGaAs. In some embodiments, one of layers 108 or layers 106 includes group IV semiconductor material, and the other of layers 108 or layers 106 includes group III-V semiconductor material. For instance, in some such embodiments, one of layers 108 or layers 106 includes SiGe or Ge, and the other of layers 108 or layers 106 includes GaAs, InGaAs, or InP, for example.

In some embodiments, multilayer stack 104 has a thickness (dimension in the Y-axis direction) in the range of 5-200 nm (or in a subrange of 5-25, 5-50, 5-100, 10-25, 10-50, 10-80, 10-100, 10-200, 20-80, 20-100, 20-200, 40-80, 40-120, 40-200, 50-100, 50-200, or 100-200 nm) or greater, or within any other suitable range or having any other suitable value as can be understood based on this disclosure. In some embodiments, multilayer stack 104 has a thickness of at least 5, 10, 15, 20, 25, 50, 80, 100, 120, or 150 nm, and/or at most 200, 150, 120, 100, 80, 50, or 25 nm, for example. In some embodiments, sacrificial layers 108 and channel layers 106 have a thickness (dimension in the Y-axis dimension) in the range of 2-100 nm (or in a subrange of 2-10, 2-25, 2-40, 2-50, 2-75, 4-10, 4-25, 4-40, 4-50, 4-75, 4-100, 10-25, 10-40, 10-50, 10-75, 10-100, 25-40, 25-50, 25-75, 25-100, or 50-100 nm) or greater, or any other suitable value or range as can be understood based on this disclosure. In some embodiments, sacrificial layers 108 and channel layers 106 have a thickness of at least 2, 5, 8, 10, 15, 20, 25, or 50 nm, and/or a height of at most 100, 75, 50, 40, 30, 25, 20, 15, 12, or 10 nm, for example. In some embodiments, sacrificial layers 108 and channel layers 106 all have the same thicknesses. However, in other embodiments, the thicknesses may differ. For instance, in some embodiments, the thicknesses of sacrificial layers 108 may all be the same, and the thicknesses of channel layer 106 may all be the same, but the thicknesses of layers 108 relative to layers 106 may be different (where layers 108 would be relatively thicker or thinner than layers 106). In some embodiments, the thickness of a sacrificial layer 108 is different relative to another sacrificial layer 108 and/or the thickness of a channel layer 106 is different relative to another channel layer 106. Moreover, the thicknesses of the channel layers 106 may be affected by the selective etch processing used to at least partially remove sacrificial layers 108 and release layers 106 from layers 108, as can be understood based on this disclosure.

Isolation or STI regions, in some embodiments, may include one or more dielectrics, such as one or more oxides (e.g., silicon dioxide), nitrides (e.g., silicon nitride), high-k dielectrics, low-k dielectrics, and/or any other suitable electrically insulating material as will be apparent in light of this disclosure. In some embodiments, isolation regions may include silicon, oxygen, nitrogen, and/or carbon. For instance, in some embodiments, isolation regions may include silicon dioxide, silicon nitride, silicon oxynitride, and/or carbon-doped silicon dioxide (or other carbon-doped oxides).

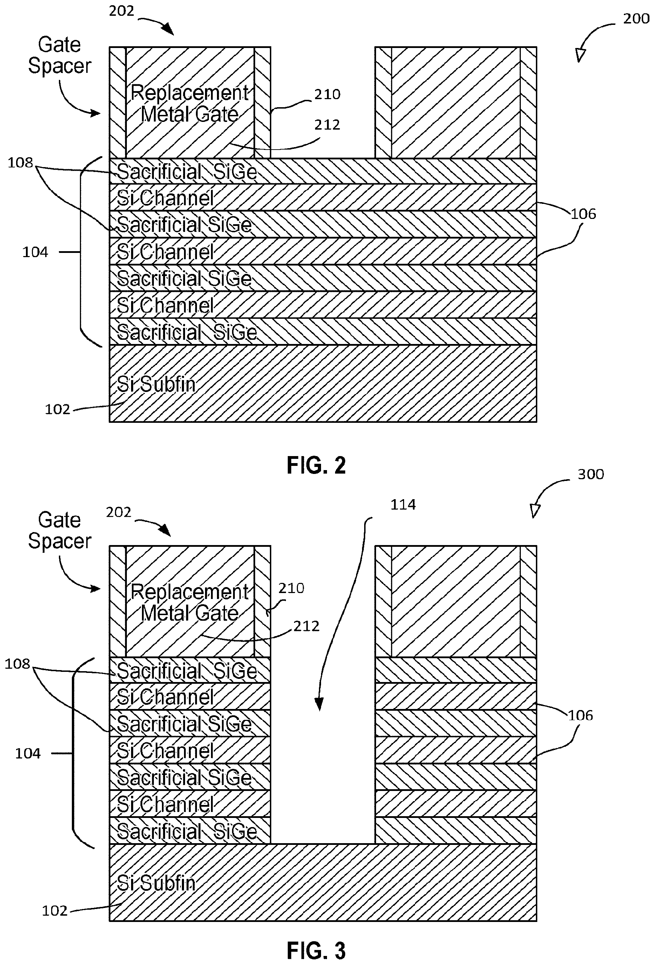

Referring to Fig. 2, a second operation includes providing a structure 200 including structure 100, and the provision of dummy gate structures 202 including gate spacers 210 and replacement metal gates (such as poly gates) 212 onto the structure 100. Forming the dummy gate structures, in accordance with some embodiments may include forming a dummy gate dielectric (e.g., dummy oxide material) and a dummy gate electrode (e.g., dummy poly-silicon material) to be used for replacement gate processing in a gate-last process flow, as can be understood based on this disclosure. In some embodiments, dummy gate structure 202 include any suitable sacrificial material that can be later removed to access multilayer stack 104. Dummy gate structures 202, in some embodiments, can be formed using any suitable techniques, such as depositing the material of dummy gate structures 202 and then patterning and etching it to form the structures shown in Fig. 2. An optional hard mask material (e.g., including dielectric material) may also be formed on replacement metal gates 212 to help protect those structures during subsequent processing, in this example embodiment. However, such hard masks need not be utilized, in some embodiments. Gate side-wall spacers 210, referred to herein as gate spacers (or simply, spacers) are also formed on either side of the dummy gate structures 202. Such gate spacers 210 can be formed using any suitable techniques, such as depositing the material of gate spacers 210 and performing spacer pattern and etch processing, for example. In some embodiments, the gate spacers 210 are used to help determine the final gate length and/or channel length, and to help with the replacement gate processing. In some embodiments, gate spacers 210 include any dielectric material, such as an oxide (e.g., silicon dioxide), nitride (e.g., silicon nitride), high-k dielectric, low-k dielectric, and/or any other suitable electrically insulating material as can be understood based on this disclosure. In some embodiments, gate spacers 210 include silicon, oxygen, nitrogen, and/or carbon. For instance, in some embodiments, gate spacers 210 include silicon dioxide, silicon monoxide, silicon nitride, silicon oxynitride, or carbon-doped silicon dioxide (or other carbon-doped oxides). In some embodiments, it is desired to select material for gate spacers 210 that has a low dielectric constant and a high breakdown voltage. In some embodiments, gate spacers 210 include a multilayer structure (e.g., a bilayer structure where the sub-layers are laterally adjacent to each other), even though it is illustrated as a single layer in the example structure 200 of Fig. 2.

Referring to Fig. 3, a third operation includes providing a structure 300 by performing a vertical etch (or a vertical etch undercut (EUC) or spacer 1 etch) through the superlattice stack 104 of structure 200 to open up a trench 114 for a source/drain structure. Note that the designation source/drain is used herein to refer to either a source or a drain or both, as the regions may be similar in the end structure but be differentiated based on how the device is electrically connected. In some embodiments, source/drain trenches 114 can be formed using any suitable techniques, such as etching (via wet and/or dry etch processing) multilayer stack 104 in the exposed locations.

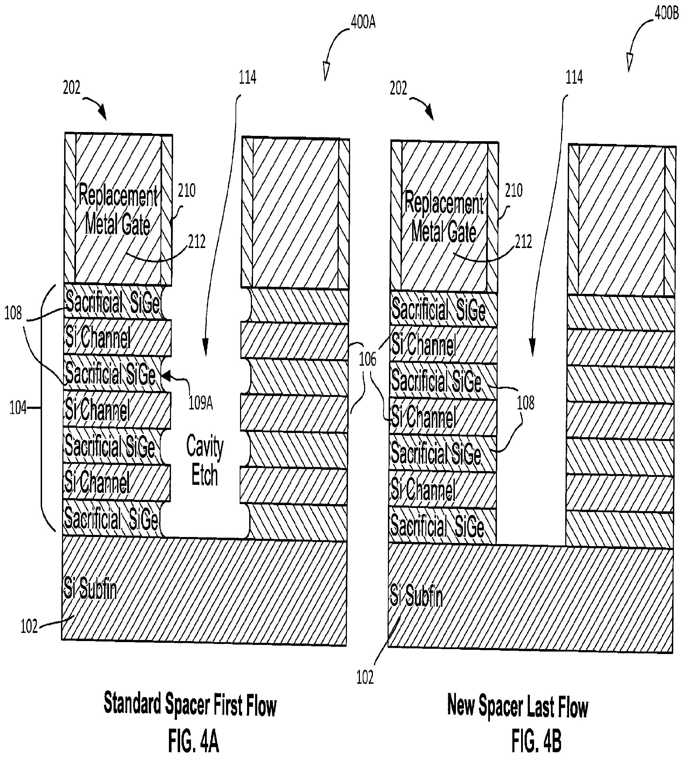

It is after the operation associated with Fig. 3 that example embodiments diverge with respect to the state of the art, starting with Figs. 4A and 4B.

In particular, referring to Fig. 4A, a fourth operation of the state of the art includes providing a structure 400A by performing a inner spacer etch into the sacrificial layers 108 to provide inner spacer recesses 109A therein, the inner spacer recesses 109A providing a concave configuration facing trench 114 of the source/drain structure. For the inner spacer etch, a selective timed etch may be used to remove a small portion of the Sacrificial layers 108 in the superlattice stack 104. The etch front of this cavity presenting the concave configuration noted above is due to the nature of the etch, and also to some interdiffusion of the SiGe/Si interface that resulted in a layer of lower Ge% SiGe which etches slower at the regions of the Sacrificial layers 108 adjacent the channel layers 106.

Referring to Fig. 4B, according to example embodiment, no inner spacer etch is performed, and the same structure as structure 300 of Fig. 3 remains. A purpose of Fig. 4B, which is identical to Fig. 3, is to show the diverging flow as between the state of the art and example embodiments.

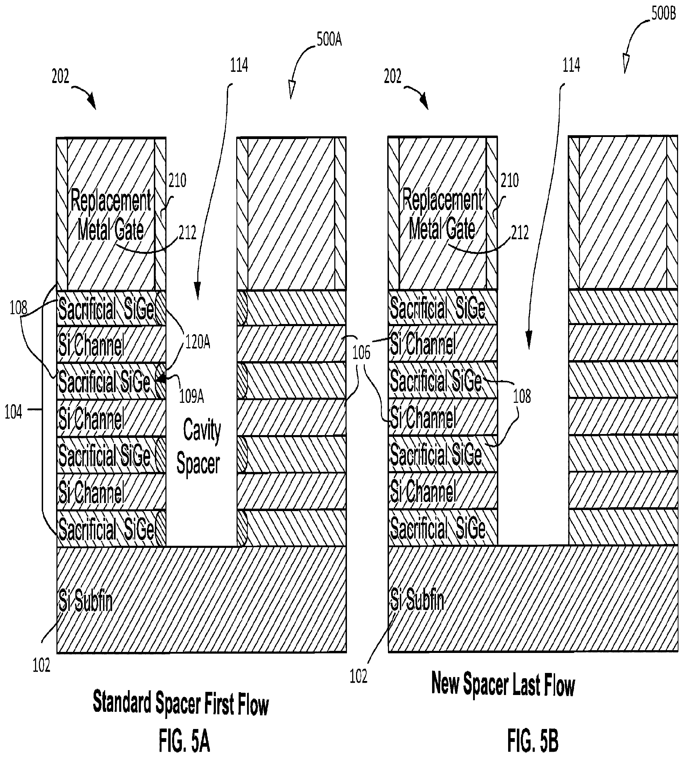

Referring to Fig. 5A, a fifth operation of the state of the art includes providing a structure 500A by providing inner spacers 120A into respective inner spacer recesses 109A of structure 400A of Fig. 4A.

Inner spacers 120A can be formed using any suitable technique. The inner spacer material 120A is deposited by ALD in the recesses 109A formed by selectively etching sacrificial layers 311. Further, the inner spacer material may be formed elsewhere, such as on gate spacers 210 and the outside of channel layers 106, but it may be etched by an isotropic etch to remove the inner spacer material that is not located inside the sacrificial layer recesses 109A, for example. However, in other embodiments, a remainder of inner spacer material is intentionally kept at the bottom of the source/drain trenches, where that remainder serves to electrically isolate the source/drain structures from the subfin.

Referring to Fig. 5B, according to example embodiment, no inner spacer etch was performed and no inner spacer is provided in any recesses of the structure 300 of Fig. 3. Therefore, similar to Fig. 4B, the same structure as structure 300 of Fig. 3 remains. A purpose of Fig. 5B, which, similar to Fig. 4B, is identical to Fig. 3, is to show the diverging flow as between the state of the art and example embodiments.

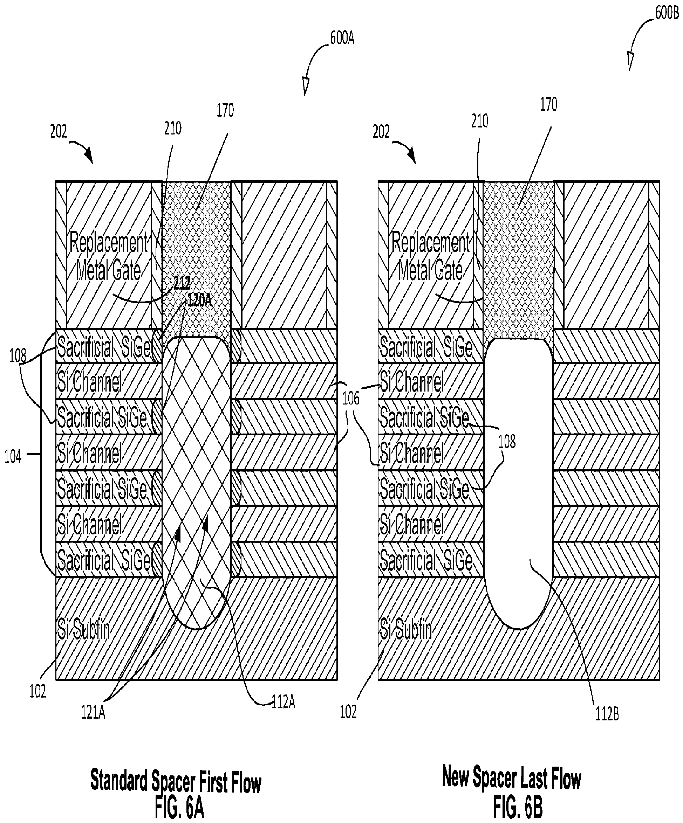

Referring to Fig. 6A, a fifth operation of the state of the art includes providing a structure 600A by depositing an epitaxial source/drain material into the trench 114 of structure 500A. When using the state of the art flow, the resulting source/drain structure 112A includes a positive epitaxial (p-EPI) material that grows from at least seven distinct growth surfaces, including surfaces 1, 2, 3, 4, 5, 6 and 7 as seen on Fig. 6A, surfaces 1-6 corresponding to surfaces of different channels, and surface 7 corresponding to the surface of the silicon subfin, noting that the source/drain epitaxial material will not grow from the material of the inner spacers 120A. Growth of the source/drain p-EPI material from discontinuities as presented by the material of the channels 106, such as silicon (noting that the epitaxial material will not grow from the material of the inner spacers, such as a low k material including SiOC), will result in multiple independent and incoherent growth fronts including two times the number of shown wires, these growth fronts, and the resulting discontinuities/crystallographic defects 121A, originate from the growth surfaces presented by the channels and expand toward a center region of the source/drain structure 112A. As these independent growth island merge, the crystallographic dislocations 121A are likely to form, presenting locations that act to remove any stress the source/drain structure can impart on the channel.

Referring to Fig. 6B, a fourth operation according to an example embodiments includes providing a structure 600B by depositing an epitaxial source/drain material into the trench 114 of structure 300. When using the example flow of Fig. 6B, the resulting source/drain structure 112B includes a p-EPI material that grows from continuous growth surface as presented by the sacrificial SiGe layers and the Si channel layers, and the Si subfin surface within trench 114. Growth of the source/drain p-EPI material from a continuous growth surface will result in a uniform growth front resulting in a substantially crystallographic defect free source/drain structure 112B, that act on the channels 106 such that an integrated average of strains in the channels exhibits a total compressive strain, and where the source/drain structures are substantially free of crystallographic defects. In particular, source/drain structures of a GAA transistor according to embodiments, such as the example embodiment shown in the form of structure 600B, unlike structure 600A of Fig. 6A, do not exhibit a pattern of crystallographic defects extending from inner spacer regions adjacent the metal gate.

In some embodiments, source/drain material of structures 112B can be epitaxially grown as semiconductor material from the exposed outer portions of channel layers 106 and sacrificial layers 108.
Source/drain structures 112B, in some embodiments, include semiconductor material. In some such embodiments, source/drain structures 112B include group IV and/or group III-V semiconductor material. This, in some embodiments, source/drain structures 112B include one or more of silicon, germanium, tin, carbon, indium, gallium, aluminum, arsenic, nitrogen, phosphorous, arsenic, or antimony. In some embodiments, source/drain structures 112B include the same group-type of semiconductor material that channel layers 106 include. For instance, in some such embodiments where channel layers 106 include group IV semiconductor material (e.g., Si, SiGe, Ge), source/drain structures 112B also include group IV semiconductor material. Further, in some embodiments where channel layers 106 include group III-V semiconductor material (e.g., GaAs, InGaAs, InP), source/drain structures 112B also include group III-V semiconductor material. However, in other embodiments, one of channel layers 106 or source/drain structures 112B include group IV semiconductor material, and the other of channel layers 106 or source/drain structures 112B include group III-V semiconductor material. In an example embodiment, source/drain structures 112B include semiconductor material that includes germanium (e.g., in a concentration in the range of 1-100 atomic percent), which may or may not also include silicon (e.g., such that the semiconductor material is either Ge or SiGe). In another example embodiment, source/drain structures 112B include gallium and arsenic, which may or may not also include indium (e.g., such that the semiconductor material is either GaAs or InGaAs).

In some embodiments, the semiconductor material included in source/drain structures 112B includes dopant, such as p-type dopant for a pMOS transistor device. The source/drain structure 112B may include Si or SiGe with a relatively low Ge concentration (e.g., 0-30 atomic percent), or a SiGe or Ge with a relatively high Ge concentration (e.g., 30-100 atomic percent).

After deposition of the source/drain structures, a dielectric layer 170, which may be considered an interlayer dielectric (ILD) layer is formed over the source/drain structures to protect the source/drain structures during subsequent processing, for example. In some such embodiments, the dielectric layer 170 includes one or more dielectrics, such as one or more oxides (e.g., silicon dioxide), nitrides (e.g., silicon nitride), high-k dielectrics, low-k dielectrics, and/or any other suitable electrically insulating material as can be understood based on this disclosure. In some embodiments, dielectric layer 170 includes silicon, oxygen, nitrogen, and/or carbon. For instance, in some embodiments, dielectric layer 170 includes silicon dioxide, silicon monoxide, silicon nitride, silicon oxynitride, or carbon-doped silicon dioxide (or other carbon-doped oxides). In some embodiments, it is desired to select material for dielectric layer 170 that has a low dielectric constant and a high breakdown voltage. In some embodiments, to decrease dielectric constant, dielectric layer 170 is formed to be intentionally porous, such as including at least one porous carbon-doped oxide (e.g., porous carbon-doped silicon dioxide). In embodiments where dielectric layer 170 is porous, it includes a plurality of pores throughout at least a portion of the layer. In some embodiments, dielectric layer 170 includes a multilayer structure.

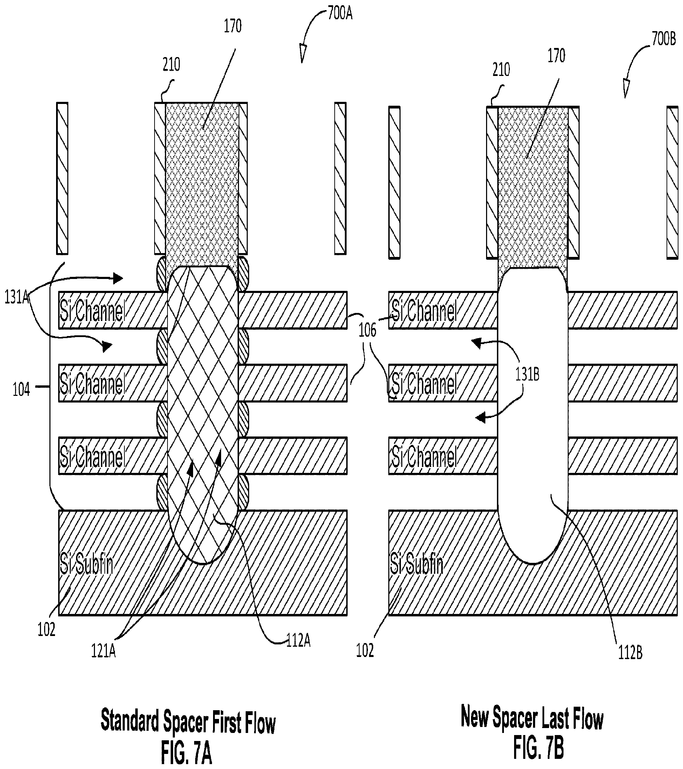

Referring to Fig. 7A, a seventh operation according to the state of the art includes providing a structure 700A by removing the replacement metal gates, selectively etching the sacrificial layers 108 to release the channels 106, where removal of the sacrificial layers 108 further releases the inner spacers 120A by creating tunnel regions 131A that extend to the inner spacers 120A.

Referring to Fig. 7B, a fifth operation according to an example embodiment includes providing a structure 700B by removing the replacement metal gates 212, selectively etching the sacrificial layers 108 to release the channels 106, where removal of the sacrificial layers 108 creates tunnel regions 131B that extend all the way to the source/drain structure 112B.

In some embodiments, replacement metal gates 212 may be removed using any suitable technique, such as by etching the materials to remove them and exposing the underlying portion of multilayer stack 104 in trenches 213. After the portions of the multilayer stack 104 are exposed by trenches 213, sacrificial layers 108 can be removed via selective etch processing (e.g., using a given etchant that removes the material of layers 108 selective to the material of layers 106). Note that although sacrificial layers 108 are shown as having been completely removed in this example embodiment, in other embodiments, a remnant of one or more of the sacrificial layers 108 may remain. In addition, in some embodiments, the processing may change the shape of channel layers 108, even though they are depicted as still having their original shape.

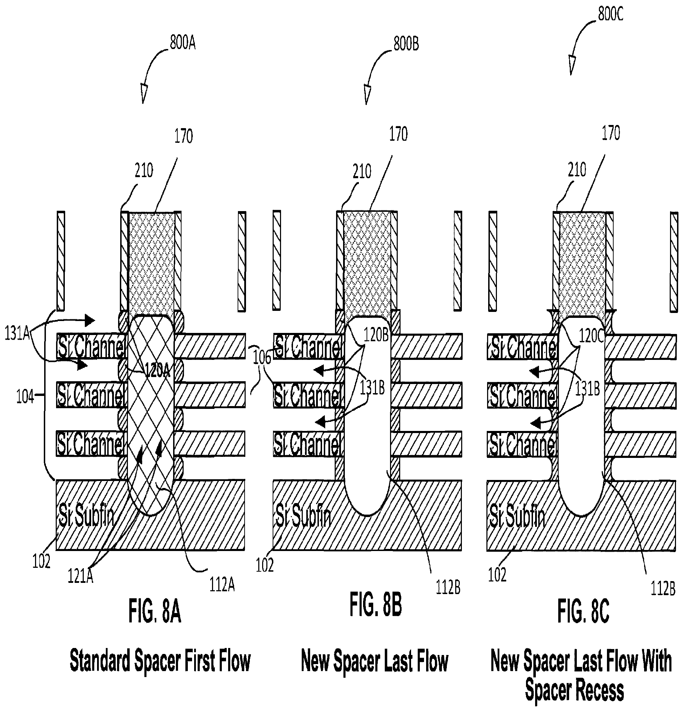

Referring to Fig. 8A, structure 800A corresponds to structure 700A of Fig. 7A, and is shown again, for the purpose of comparison with structures 800B and 800C according to some embodiments.

Referring to Figs. 8B and 8C, a sixth operation according to an example embodiment includes providing a structure 800B and 800C respectively, by providing respective sets of inner spacers 120B and 120C in the tunnel regions 131B adjacent the source/drain structure 112B. A difference between structures 800B and 800C is that while the inner spacers 120C of structure 800C define concave recesses facing away from the source/drain structures, the inner spacers 120B of structure 800B do not define such recesses as shown.

Formation of inner spacers 120B/120C may, according to an embodiment, utilize surface termination differential between SiGe in the sacrificial layers 108 and silicon in the channel layers 106. Termination differential may be utilized for selective deposition of spacer film in the opening or cavity 131B. In an embodiment, a native oxide on Si channel layers 106, may be a primary oxide and include a Si-OH termination. A passivant may be used in the selective deposition process that binds with the Si-OH termination, preventing deposition of spacer film on Si. On the other hand, a native oxide on the material in the source/drain structure 112B, is a secondary oxide because of high Ge concentration on the surface of the source/drain structure 112B. The secondary oxide does not bind with the passivant used. Thus, selective passivation is performed prior to the growth process. The selective passivation method prevents formation of a spacer material against silicon but promotes formation of spacer material from surfaces of the source/drain structure 112B between the channel layers 106 and between a channel layer 106 and substrate 102. In an exemplary embodiment, the inner spacer 120B/120C includes a material having a low dielectric constant. A dielectric constant between 1-3 may be considered a low dielectric constant material. A low dielectric constant material may be suitable when transistors are operated at sub IV. In an embodiment, a low dielectric constant inner spacer 120B/120C includes Si, O and C such as SiOC. In one or more embodiments, where the inner spacers 120B/120C includes Si, C and O, the ratio of carbon to oxygen may depend on a number of desired transistor parameters. In some embodiments, the ratio of carbon to oxygen may vary between (1:3 to 10:1). The inner spacers 120B/120C may have a uniform carbon content throughout a volume thereof.

In some embodiments, inner spacers 120B/120C include any suitable oxide (e.g., silicon dioxide), nitride (e.g., silicon nitride), or carbide (e.g. silicon oxycarbide or any SiOC), high-k dielectric, low-k dielectric, and/or any other suitable electrically insulating material as can be understood based on this disclosure. In some embodiments, inner spacers 120B/120C include silicon, oxygen, nitrogen, and/or carbon. For instance, in some embodiments, inner spacers 120B/120C include silicon dioxide, silicon monoxide, silicon nitride, silicon oxynitride, or carbon-doped silicon dioxide (or other carbon-doped oxides). In some embodiments, gate spacers 210 and inner spacers 120B/120C include the same material, while in other embodiments they include different material. In an embodiment, the inner spacer 120B is formed to fill the end region of the tunnel regions 131B adjacent the source/drain structure 112B.

In order to implement a selective deposition of the inner spacers as described above, a silicon precursor and a passivant may be used as part of the selective deposition process as suggested above. The passivant is selected such that it binds with the Si-OH termination of the silicon material of channels 106, but does not bind with the material of the source/drain structures because of the presence of Ge therein. The precursor is then to be selective to the chosen passivant. In this way, the precursor would attach to surfaces of the source/drain structures that are exposed within tunnel regions 131B, but not attach to the surfaces of the Si channels in the tunnel regions 131B. According to an embodiment, the precursor used for a selective deposition process may include a halogenated precursor. Use of a halogenated precursor would result in trapped halogen in the material of the inner spacers 120B/120C. In such a case, the inner spacers would include halogen.

In the exemplary embodiment of Fig. 8C, the growth process also forms outer concave surfaces140C on inner spacers 120C facing away from the source/drain structure 120B. The concavity of the inner spacers may be caused for example through the selective deposition process by virtue of some Ge from the sacrificial layers 108 having diffused into the channel layers 106 at interfaces thereof. As a result, deposition of a the material for the inner spacers may start happening on these interfaces as well, as the precursor may have an affinity for Ge.

Embodiments encompass within their scope the provision of inner spacers by any methods other than selective deposition. For example, a material of the inner spacers may be blanked deposited into the tunnel regions 131B, and etched away to form the inner spacers 120B/120C. the concavity of the inner spacers 120C may in any event result even where the material of the inner spacers is not selectively deposited, for example as an expected byproduct of an etching process. For example, to achieve the flatter surfaces of the inner spacers 120B, the concavity as noted above may be etched away.

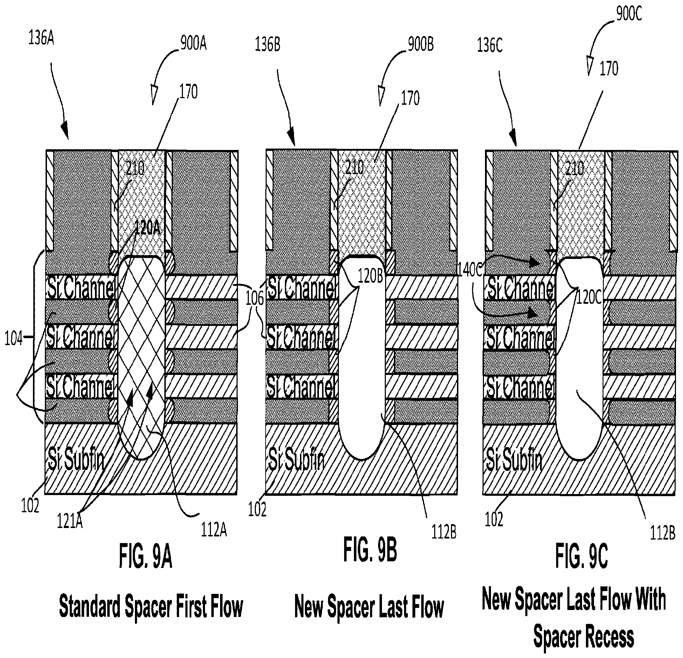

Referring to Fig. 9A, an eighth operation according to the state of the art includes providing structure 900A which includes the structure 800A of Fig. 8A but with a gate structure 136A, the gate structure including for example a gate dielectric, such as a high-k dielectric, along with a gate electric, such as a metal gate electrode.

Referring to Figs. 9B, a seventh operation according to an example embodiment includes providing structure 900B which includes the structure 800A of Fig. 8A but with a gate structure 136B included, the gate structure including for example a gate dielectric, such as a high-k dielectric, along with a gate electric, such as a metal gate electrode.

Referring to Figs. 9C, a seventh operation according to another example embodiment includes providing structure 900C which includes the structure 800C of Fig. 8C but with a gate structure 136C included, the gate structure including for example a gate dielectric, such as a high-k dielectric, along with a gate electric, such as a metal gate electrode.

In some embodiments, channel layers 106, which may be nanowires, nanoribbons, or nanosheets, could employ various different shapes, such as a circle, oval, ellipse, square, rectangle, sheet, fin, or any other shape as can be understood based on this disclosure. Regardless of the shape, the final gate structure (including gate dielectric and gate electrode) would still wrap around the channel material bodies, thereby resulting in a GAA transistor configuration, as can be understood based on this disclosure.

Gate dielectric, in some embodiments, includes one or more dielectrics, such as one or more oxides (e.g., silicon dioxide), nitrides (e.g., silicon nitride), high-k dielectrics, low-k dielectrics, and/or any other suitable material as can be understood based on this disclosure. Examples of high-k dielectrics include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. Examples of low-k dielectrics include, for instance, fluorine-doped silicon dioxide, carbon-doped silicon dioxide, porous silicon dioxide, porous carbon-doped silicon dioxide, spin-on organic polymeric dielectrics (e.g., polytetrafluoroethylene, benzocyclobutene, polynorbornenes, polyimide), spin-on silicon based polymeric dielectrics (e.g., hydrogen silsesquioxane, methylsilsesquioxane), to provide some examples. In some embodiments, an annealing process is carried out on the gate dielectric to improve its quality when, for example, high-k dielectric material is employed.

In some embodiments, the gate dielectric includes oxygen. In some such embodiments where the gate dielectric includes oxygen, the gate dielectric also includes one or more other materials, such as one or more of hafnium, silicon, lanthanum, aluminum, zirconium, tantalum, titanium, barium, strontium, yttrium, lead, scandium, zinc, lithium, or niobium. For instance, the gate dielectric may include hafnium and oxygen (e.g., in the form of hafnium oxide or hafnium silicon oxide), or the gate dielectric may include silicon and oxygen (e.g., in the form of silicon dioxide, hafnium silicon oxide, or zirconium silicon oxide), in accordance with some embodiments. In some embodiments, the gate dielectric includes nitrogen. In some such embodiments where the gate dielectric includes nitrogen, the gate dielectric may also include one or more other materials, such as silicon (e.g., silicon nitride) for instance. In some embodiments, the gate dielectric includes silicon and oxygen, such as in the form of one or more silicates (e.g., titanium silicate, tungsten silicate, niobium silicate, and silicates of other transition metals). In some embodiments, the gate dielectric includes oxygen and nitrogen (e.g., silicon oxynitride or aluminum oxynitride).

In some embodiments, the gate dielectric includes a multilayer structure, including two or more compositionally distinct layers. For example, a multilayer gate dielectric can be employed to obtain desired electrical isolation and/or to help transition from each channel layer 106 to gate electrode, in accordance with some embodiments. In an example embodiment, a multilayer gate dielectric has a first layer nearest each channel layer 106 that includes oxygen and one or more materials included in each channel layer 106 (such as silicon and/or germanium), which may be in the form of an oxide (e.g., silicon dioxide or germanium oxide), and the multilayer gate dielectric also has a second layer farthest from each channel layer 106 (and nearest the gate electrode) that includes at least one high-k dielectric (e.g., hafnium and oxygen, which may be in the form of hafnium oxide or hafnium silicon oxide). In some embodiments, gate dielectric includes grading (e.g., increasing and/or decreasing) the content/concentration of one or more materials through at least a portion of the gate dielectric, such as the oxygen content/concentration within the gate dielectric.

In some embodiments, gate dielectric has a thickness in the range of 1-30 nm (or in a sub-range of 1-5, 1-10, 1-15, 1-20, 1-25, 2-5, 2-10, 2-15, 2-20, 2-25, 2-30, 3-8, 3-12, 5-10, 5-15, 5-20, 5-25, 5-30, 10-20, 10-30, or 20-30 nm) or greater, for example, or within any other suitable range or having any other suitable value as can be understood based on this disclosure. In some embodiments, the thickness of gate dielectric is at least 1, 2, 3, 5, 10, 15, 20, or 25 nm, and/or at most 30, 25, 20, 15, 10, 8, or 5 nm, for example. Note that the thicknesses described herein for gate dielectric relate at least to the dimension between each channel layer 106 and gate electrode (e.g., at least the dimension in the Y-axis). In some embodiments, the thickness of gate dielectric is selected, at least in part, based on the desired amount of isolation between each channel layer 106 and gate electrode. In some embodiments, gate dielectric provides means for electrically insulating each channel layer 106 from gate electrode. In some embodiments, the characteristics of gate dielectric are selected based on desired electrical properties.

Gate electrode, in some embodiments, includes one or more metals, such as one or more of aluminum, tungsten, titanium, tantalum, copper, nickel, gold, platinum, ruthenium, or cobalt, for example. In some embodiments, the gate electrode includes carbon and/or nitrogen, such as in combination with one or more of the metals in the preceding sentence, for example. For instance, in some embodiments gate electrode includes titanium and nitrogen (e.g., titanium nitride), or tantalum and nitrogen (e.g., tantalum nitride), such as in a liner layer that is in direct contact with the gate dielectric, for example. Thus, in some embodiments, the gate electrode includes one or more metals that may or may not include one or more other materials (such as carbon and/or nitrogen). In some embodiments, the gate electrode includes a multilayer structure, including two or more compositionally distinct layers. For instance, in some such embodiments, one or more work function layers are employed, such as one or more metal-including layers that are formed with desired electrical characteristics. Further, in some such embodiments, the one or more metal-including layers include tantalum and/or titanium, which may also include nitrogen (e.g., in the form of tantalum nitride or titanium nitride). In some embodiments, a bulk metal structure is formed on and between a conformal layer (such as a liner layer), where the bulk metal structure includes compositionally distinct material from the conformal/liner layer.

In some embodiments, the gate electrode includes a resistance reducing metal layer between a bulk metal structure and the gate dielectric, for instance. Example resistance reducing metals include, for instance one or more of nickel, titanium, titanium with nitrogen (e.g., titanium nitride), tantalum, tantalum with nitrogen (e.g., tantalum nitride), cobalt, gold, gold with germanium (e.g., gold-germanium), nickel, platinum, nickel with platinum (e.g., nickel-platinum), aluminum, and/or nickel with aluminum (e.g., nickel aluminum), for instance. Example bulk metal structures include one or more of aluminum, tungsten, ruthenium, copper, or cobalt, for instance. In some embodiments, the gate electrode includes additional layers, such as one or more layers including titanium and nitrogen (e.g., titanium nitride) and/or tantalum and nitrogen (e.g., tantalum nitride), which can be used for adhesion and/or liner/barrier purposes, for example. In some embodiments, the thickness, material, and/or deposition process of sub-layers within a multilayer gate electrode are selected based on a target application, such as whether the gate electrode is to be used with an n-channel device or a p-channel device. In some embodiments, the gate electrode provides means for changing the electrical attributes of each adjacent channel layer 106 when a voltage is applied to the gate electrode.

In some embodiments, the gate electrode has a thickness (dimension in the direction from the subfin toward the channels) in the range of 10-100 nm (or in a sub-range of 10-25, 10-50, 10-75, 20-30, 20-50, 20-75, 20-100, 30-50, 30-75, 30-100, 50-75, or 50-100 nm) or greater, for example, or within any other suitable range or having any other suitable value as can be understood based on this disclosure. In an embodiment, the gate electrode has a thickness that falls within the sub-range of 20-40 nm. In some embodiments, the gate electrode has a thickness of at least 10, 15, 20, 25, 30, 40, or 50 nm and/or at most 100, 50, 40, 30, 25, or 20 nm, for example. In some embodiments, the gate electrode includes grading (e.g., increasing and/or decreasing) the content/concentration of one or more materials through at least a portion of the structure.

After structures 900A/900B/900C are provided as shown in Figs. 9A/9B/9C, source/drain contact structures may be provided in a well-known manner. In some embodiments, the source/drain contact structure formation includes forming source/drain contact trenches in dielectric or ILD layer 170 via etch processing in which the source/drain contact structures 190 can be formed. In some such embodiments, dielectric or ILD layer 170 is completely removed between gate spacers 210 and above source/drain contact structures 190, such as is shown in Figs. 9A/9B/9C. However, in other embodiments, a portion of dielectric layer 170 may remain between the gate spacers 210.

Source/drain contact structures 190, in some embodiments, include one or more metals. For instance, one or both of source/drain contact structures may include a resistance reducing metal and a contact plug metal, or just a contact plug, for instance. Example contact resistance reducing metals include, for instance, nickel, titanium, titanium with nitrogen (e.g., in the form of titanium nitride), tantalum, tantalum with nitrogen (e.g., in the form of tantalum nitride), cobalt, gold, gold-germanium, nickel-platinum, nickel aluminum, and/or other such resistance reducing metals or alloys. Example contact plug metals include, for instance, aluminum, tungsten, ruthenium, or cobalt, although any suitable conductive material could be employed. In some embodiments, additional layers are present in the source/drain contact trenches, where such additional layers would be a part of the source/drain contact structures 190. Examples of additional layers include adhesion layers and/or liner/barrier layers, that include, for example, titanium, titanium with nitrogen (e.g., in the form of titanium nitride), tantalum, and/or tantalum with nitrogen (e.g., in the form of tantalum nitride). Another example of an additional layer is a contact resistance reducing layer between a given source/drain structure 360 and its corresponding source/drain contact structure 190, where the contact resistance reducing layer includes semiconductor material and relatively high dopant (e.g., with dopant concentrations greater than 1¹⁹, 1²⁰, 1²¹, 5²¹, or 1²² atoms per cubic cm), for example. After formation of the source/drain contacts 190, further processing may continue with completing integrated circuit processing, as desired, in accordance with some embodiments. Such additional processing to complete the integrated circuit can include back-end or back-end-of-line (BEOL) processing to form one or more metallization layers and/or to interconnect the devices formed during the front-end or front-end-of-line (FEOL) processing, such as the transistor devices described herein.

According to some embodiments, as part of forming a GAA transistor device, the source/drain structures are deposited before provision of inner spacers, and the inner spacers are deposited after release of the sacrificial layers and prior to provision of the high-k gate dielectric material and gate electrodes. As a result, the source/drain structures can grow from a growth surface that, in one embodiment, has sections of both Si and SiGe, although the entire growth surface will be substantially both continuous and coherent. As a result, the source/drain structures are substantially free of crystallographic defects. In particular, source/drain structures of a GAA transistor according to embodiments, such as the example embodiment shown in the form of structures 900B and 900C, unlike structure 900A, do not exhibit a pattern of crystallographic defects extending from inner spacer regions adjacent the metal gate.

Substantially defect free p-EPI source/drain structures can advantageously impart strain on the channels. Inner spacer deposition may then take place before deposition of the high-k and metal gate. The inner spacers are to prevent source/drain to metal gate shorts. Because the inner spacers are, according to some embodiments, to be deposited without a cavity etch, they will not exhibit a convex shape in a direction facing away from the source/drain structures, such as shown for example in Fig. 9A. According to one embodiment, the inner spacers may define a concave shape or curvature facing away from the source/drain structures, as shown for example in Fig. 9C, an inverse of a typical shape of inner spacers of the state of the art. According to some embodiments, after the high-k and metal gate deposition, a process flow may proceed in a well-known manner.

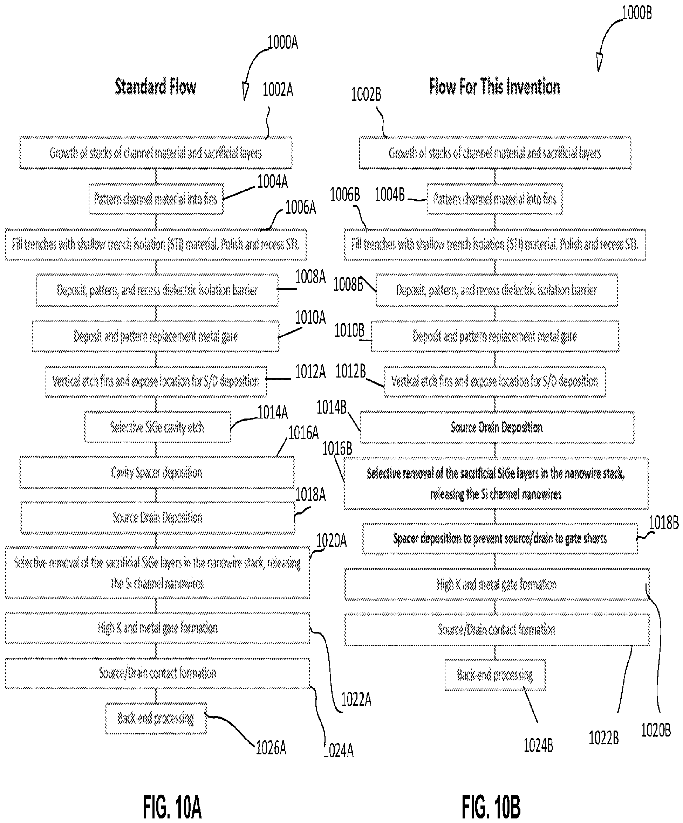

Fig. 10A illustrates a method of forming a GAA transistor device according to the state of the art, while Fig. 10B illustrates a method of forming a GAA transistor device according to some embodiments.

As shown in Fig. 10A, a spacer first flow 1000A according to the state of the art includes, at operation 1002A, growing stacks of channel materials and sacrificial layers on a subfin; at operation 1004A, patterning the channel material into fins; at operation 1006A, filling trenches with shallow trench isolation (STI) material, polishing and recessing the STI; at operation 1008A, depositing, patterning and recessing a dielectric isolation barrier (or gate spacers); at operation 1010A, depositing and patterning a replacement metal gate; at operation 1012A, performing a vertical etch of fins to expose locations for the source/drain deposition; at operation 1014A, performing a selective etch of the sacrificial SiGe layers to form cavities therein; at operation 1016A, depositing inner spacers in the cavities; at operation 1018A, depositing the source/drain materials; at operation 1020A, selectively removing the sacrificial SiGe layers in the channel stack to release the Si channels; at operation 1022A, forming the high-k metal gate gate structures; at operation 1024A, forming source/drain contacts; and at operation 1026A, performing back end processing.

As shown in Fig. 10B, a spacer last flow 1000B according to the state of the art includes, at operation 1002B, growing stacks of channel materials and sacrificial layers on a subfin; at operation 1004B, patterning the channel material into fins; at operation 1006B, filling trenches with shallow trench isolation (STI) material, polishing and recessing the STI; at operation 1008B, depositing, patterning and recessing a dielectric isolation barrier (or gate spacers); at operation 1010B, depositing and patterning a replacement metal gate; at operation 1012B, performing a vertical etch of fins to expose locations for the source/drain deposition; at operation 1014B, depositing the source/drain materials; at operation 1016B, selectively removing the sacrificial SiGe layers in the channel stack to release the Si channels; at operation 1018B, depositing inner spacers in between the channels; at operation 1020B, forming the high-k metal gate gate structures; at operation 1022B, forming source/drain contacts; and at operation 1024B, performing back end processing.

The presence of a substantially defect free source/drain structure, along with the presence of compressive strain the adjacent channel regions, as described above will be identifiable in TEM images and TEM nano-beam electron diffraction or Raman spectroscopy strain measurements. The standard flow today results in substantially no overall channel strain from p-EPI source/drain structures. Strain from p-EPI can be distinguished from other sources of channel strain for example by measuring strain versus fin length.

Switching to a process according to embodiments where inner spacers are provided after provision of the source/drain structures and before provision of the gate structures (gate dielectric and gate electrodes) (a "spacer last flow") will enable a substantially defect free p-EPI source/drain deposition (visible in TEM) and compressive channel strain (measurable via TEM or Raman). Finally, a shape of inner spacers and their associated gate structures will change with a spacer last flow as compared with the state of the art (a "spacer first flow"). In a spacer first flow, the cavity etch results in the spacer having a curvature or convex on the gate side, with the spacer being thinner (as measured in a direction perpendicularly away from a surface of the source/drain structure) when it is closer to an adjacent channel than at a middle region thereof in line with the gate material. In a spacer first flow, a cavity etch is a timed etch into a SiGe layer (sacrificial layer), and an over-etch to completely remove all material near the Si channel is not possible. In a spacerlast flow according to example embodiments however, inner spacers are deposited after channel release, that is, after sacrificial SiGe has been removed. The above enables a more uniform deposition of the inner spacer material, and, if f there is an inner spacer recess or concavity present after inner spacer deposition, it would result in curvature of the spacer material that is in general an inverse of the curvature of inner spacers provided using the spacer first flow of the state of the art.

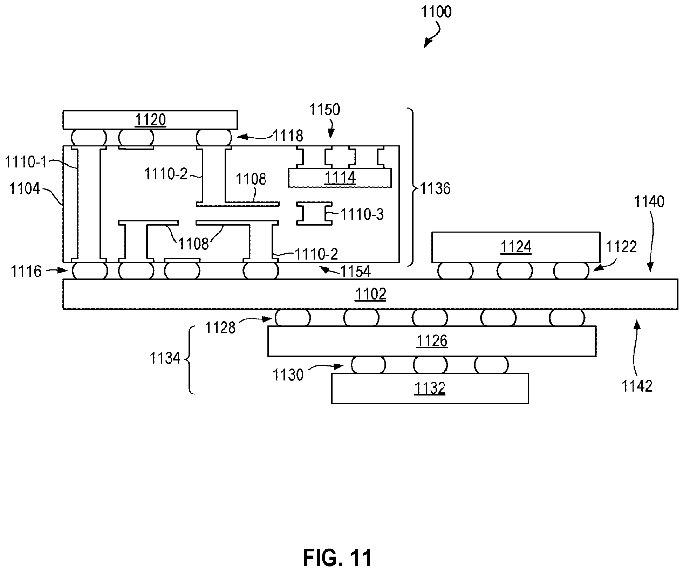

Fig. 11 is a cross-sectional side view of an integrated circuit device assembly 1100 that may include one or more integrated circuit structures each including any of the GAA transistor devices described herein. The integrated circuit device assembly 1100 includes a number of components disposed on a circuit board 1102 (which may be a motherboard, system board, mainboard, etc.). The integrated circuit device assembly 1100 includes components disposed on a first face 1140 of the circuit board 1102 and an opposing second face 1142 of the circuit board 1102; generally, components may be disposed on one or both faces 1140 and 1142. Any of the integrated circuit components discussed below with reference to the integrated circuit device assembly 1100 may include an integrated circuit structure including transistor device embodiments as disclosed herein.

In some embodiments, the circuit board 1102 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1102. In other embodiments, the circuit board 1102 may be a non-PCB substrate. The integrated circuit device assembly 1100 illustrated in Fig. 11 includes a package-on-interposer structure 1136 coupled to the first face 1140 of the circuit board 1102 by coupling components 1116. The coupling components 1116 may electrically and mechanically couple the package-on-interposer structure 1136 to the circuit board 1102, and may include solder balls (as shown in Fig. 11), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1136 may include an integrated circuit component 1120 coupled to an interposer 1104 by coupling components 1118. The coupling components 1118 may take any suitable form for the application, such as the forms discussed above with reference to the coupling components 1116. Although a single integrated circuit component 1120 is shown in Fig. 11, multiple integrated circuit components may be coupled to the interposer 1104; indeed, additional interposers may be coupled to the interposer 1104. The interposer 1104 may provide an intervening substrate used to bridge the circuit board 1102 and the integrated circuit component 1120.

The integrated circuit component 1120 may be a packaged or unpackaged integrated circuit product that includes one or more integrated circuit dies including transistor devices such as those shown in Figs. 9B and 9C. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1120, a single monolithic integrated circuit die comprises solder bumps attached to contacts on the die. The solder bumps allow the die to be directly attached to the interposer 1104. The integrated circuit component 1120 can comprise one or more computing system components, such as one or more processor units (e.g., system-on-α-chip (SoC), processor core, graphics processor unit (GPU), accelerator, chipset processor), I/O controller, memory, or network interface controller. In some embodiments, the integrated circuit component 1120 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1120 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1120 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1104 may spread connections to a wider pitch or reroute a connection to a different connection. For example, the interposer 1104 may couple the integrated circuit component 1120 to a set of ball grid array (BGA) conductive contacts of the coupling components 1116 for coupling to the circuit board 1102. In the embodiment illustrated in Fig. 11, the integrated circuit component 1120 and the circuit board 1102 are attached to opposing sides of the interposer 1104; in other embodiments, the integrated circuit component 1120 and the circuit board 1102 may be attached to a same side of the interposer 1104. In some embodiments, three or more components may be interconnected by way of the interposer 1104.

In some embodiments, the interposer 1104 may be formed as a PCB, including multiple metal layers separated from one another by layers of dielectric material and interconnected by electrically conductive vias. In some embodiments, the interposer 1104 may be formed of an epoxy resin, a fiberglass-reinforced epoxy resin, an epoxy resin with inorganic fillers, a ceramic material, or a polymer material such as polyimide. In some embodiments, the interposer 1104 may be formed of alternate rigid or flexible materials that may include the same materials described above for use in a semiconductor substrate, such as silicon, germanium, and other group III-V and group IV materials. The interposer 1104 may include metal interconnects 1108 and vias 1110, including but not limited to through hole vias 1110-1 (that extend from a first face 1150 of the interposer 1104 to a second face 1154 of the interposer 1104), blind vias 1110-2 (that extend from the first or second faces 1150 or 1154 of the interposer 1104 to an internal metal layer), and buried vias 1110-3 (that connect internal metal layers).

In some embodiments, the interposer 1104 can comprise a silicon interposer. Through silicon vias (TSV) extending through the silicon interposer can connect connections on a first face of a silicon interposer to an opposing second face of the silicon interposer. In some embodiments, an interposer 1104 comprising a silicon interposer can further comprise one or more routing layers to route connections on a first face of the interposer 1104 to an opposing second face of the interposer 1104.

The interposer 1104 may further include embedded devices 1114, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1104. The package-on-interposer structure 1136 may take the form of any of the package-on-interposer structures known in the art. In embodiments where the interposer is a nonprinted circuit board

The integrated circuit device assembly 1100 may include an integrated circuit component 1124 coupled to the first face 1140 of the circuit board 1102 by coupling components 1122. The coupling components 1122 may take the form of any of the embodiments discussed above with reference to the coupling components 1116, and the integrated circuit component 1124 may take the form of any of the embodiments discussed above with reference to the integrated circuit component 1120.

The integrated circuit device assembly 1100 illustrated in Fig. 11 includes a package-on-package structure 1134 coupled to the second face 1142 of the circuit board 1102 by coupling components 1128. The package-on-package structure 1134 may include an integrated circuit component 1126 and an integrated circuit component 1132 coupled together by coupling components 1130 such that the integrated circuit component 1126 is disposed between the circuit board 1102 and the integrated circuit component 1132. The coupling components 1128 and 1130 may take the form of any of the embodiments of the coupling components 1116 discussed above, and the integrated circuit components 1126 and 1132 may take the form of any of the embodiments of the integrated circuit component 1120 discussed above. The package-on-package structure 1134 may be configured in accordance with any of the package-on-package structures known in the art.

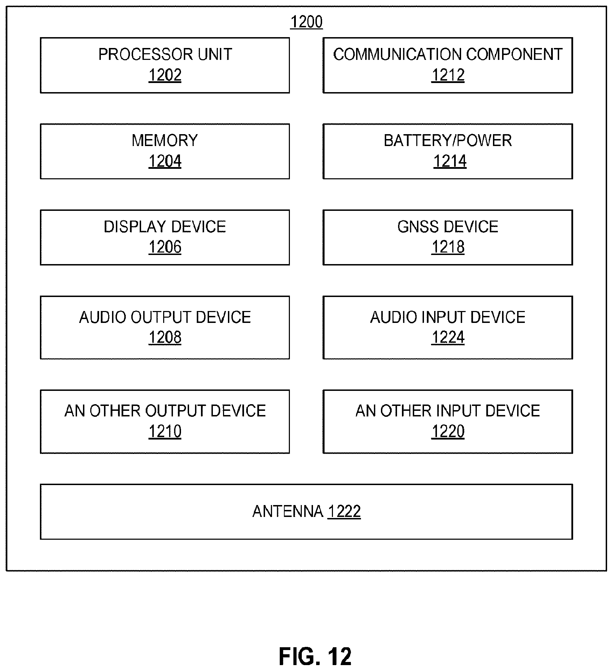

Fig. 12 is a block diagram of an example electrical device 1200 that may include one or more of the transistor devices of embodiments disclosed herein. For example, any suitable ones of the components of the electrical device 1200 may include one or more of the integrated circuit device assemblies 1100, integrated circuit components 1120, and/or transistor device embodiments disclosed herein. A number of components are illustrated in Fig. 12 as included in the electrical device 1200, but any one or more of these components may be omitted or duplicated, as suitable for the application. In some embodiments, some or all of the components included in the electrical device 1200 may be attached to one or more motherboards mainboards, or system boards. In some embodiments, one or more of these components are fabricated onto a single system-on-α-chip (SoC) die.

Additionally, in various embodiments, the electrical device 1200 may not include one or more of the components illustrated in Fig. 12, but the electrical device 1200 may include interface circuitry for coupling to the one or more components. For example, the electrical device 1200 may not include a display device 1206, but may include display device interface circuitry (e.g., a connector and driver circuitry) to which a display device 1206 may be coupled. In another set of examples, the electrical device 1200 may not include an audio input device 1224 or an audio output device 1208, but may include audio input or output device interface circuitry (e.g., connectors and supporting circuitry) to which an audio input device 1224 or audio output device 1208 may be coupled.

The electrical device 1200 may include one or more processor units 1202 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1202 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1200 may include a memory 1204, which may itself include one or more memory devices such as volatile memory (e.g., dynamic random access memory (DRAM), static random-access memory (SRAM)), non-volatile memory (e.g., readonly memory (ROM), flash memory, chalcogenide-based phase-change non-voltage memories), solid state memory, and/or a hard drive. In some embodiments, the memory 1204 may include memory that is located on the same integrated circuit die as the processor unit 1202. This memory may be used as cache memory (e.g., Level 1 (LI), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1200 can comprise one or more processor units 1202 that are heterogeneous or asymmetric to another processor unit 1202 in the electrical device 1200. There can be a variety of differences between the processing units 1202 in a system in terms of a spectrum of metrics of merit including architectural, microarchitectural, thermal, power consumption characteristics, and the like. These differences can effectively manifest themselves as asymmetry and heterogeneity among the processor units 1202 in the electrical device 1200.

In some embodiments, the electrical device 1200 may include a communication component 1212 (e.g., one or more communication components). For example, the communication component 1212 can manage wireless communications for the transfer of data to and from the electrical device 1200. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1212 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1212 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1212 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1212 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1212 may operate in accordance with other wireless protocols in other embodiments. The electrical device 1200 may include one or more antennas, such as antenna 1222 to facilitate wireless communications and/or to receive other wireless communications (such as AM or FM radio transmissions).

In some embodiments, the communication component 1212 may manage wired communications, such as electrical, optical, or any other suitable communication protocols (e.g., IEEE 802.3 Ethernet standards). As noted above, the communication component 1212 may include multiple communication components. For instance, a first communication component 1212 may be dedicated to shorter-range wireless communications such as Wi-Fi or Bluetooth, and a second communication component 1212 may be dedicated to longer-range wireless communications such as global positioning system (GPS), EDGE, GPRS, CDMA, WiMAX, LTE, EV-DO, or others. In some embodiments, a first communication component 1212 may be dedicated to wireless communications, and a second communication component 1212 may be dedicated to wired communications.

The electrical device 1200 may include battery/power circuitry 1214. The battery/power circuitry 1214 may include one or more energy storage devices (e.g., batteries or capacitors) and/or circuitry for coupling components of the electrical device 1200 to an energy source separate from the electrical device 1200 (e.g., AC line power).

The electrical device 1200 may include a display device 1206 (or corresponding interface circuitry, as discussed above). The display device 1206 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1200 may include an audio output device 1208 (or corresponding interface circuitry, as discussed above). The audio output device 1208 may include any embedded or wired or wirelessly connected external device that generates an audible indicator, such speakers, headsets, or earbuds.

The electrical device 1200 may include an audio input device 1224 (or corresponding interface circuitry, as discussed above). The audio input device 1224 may include any embedded or wired or wirelessly connected device that generates a signal representative of a sound, such as microphones, microphone arrays, or digital instruments (e.g., instruments having a musical instrument digital interface (MIDI) output). The electrical device 1200 may include a Global Navigation Satellite System (GNSS) device 1218 (or corresponding interface circuitry, as discussed above), such as a Global Positioning System (GPS) device. The GNSS device 1218 may be in communication with a satellitebased system and may determine a geolocation of the electrical device 1200 based on information received from one or more GNSS satellites, as known in the art.

The electrical device 1200 may include another output device 1210 (or corresponding interface circuitry, as discussed above). Examples of the other output device 1210 may include an audio codec, a video codec, a printer, a wired or wireless transmitter for providing information to other devices, or an additional storage device.

The electrical device 1200 may include another input device 1220 (or corresponding interface circuitry, as discussed above). Examples of the other input device 1220 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1200 may have any desired form factor, such as a handheld or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1200 may be any other electronic device that processes data. In some embodiments, the electrical device 1200 may comprise multiple discrete physical components. Given the range of devices that the electrical device 1200 can be manifested as in various embodiments, in some embodiments, the electrical device 1200 can be referred to as a computing device or a computing system.

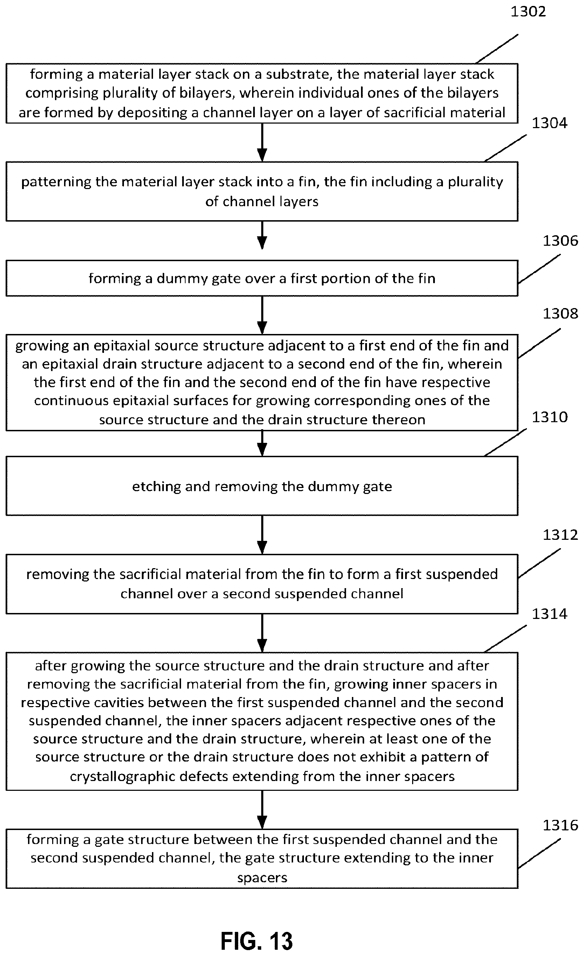

Fig. 13 is a flow chart of a process 1300 according to some embodiments. At operation 1302, the process includes forming a material layer stack on a substrate, the material layer stack comprising plurality of bilayers, wherein individual ones of the bilayers are formed by depositing a channel layer on a layer of sacrificial material; at operation 1304, the process includes patterning the material layer stack into a fin, the fin including a plurality of channel layers; at operation 1306, the process includes forming a dummy gate over a first portion of the fin; at operation 1308, the process includes growing an epitaxial source structure adjacent to a first end of the fin and an epitaxial drain structure adjacent to a second end of the fin, wherein the first end of the fin and the second end of the fin have respective continuous epitaxial surfaces for growing corresponding ones of the source structure and the drain structure thereon; at operation 1310, the process includes etching and removing the dummy gate; at operation 1312, the process includes removing the sacrificial material from the fin to form a first suspended channel over a second suspended channel; at operation 1314, the process includes after growing the source structure and the drain structure and after removing the sacrificial material from the fin, growing inner spacers in respective cavities between the first suspended channel and the second suspended channel, the inner spacers adjacent respective ones of the source structure and the drain structure, wherein at least one of the source structure or the drain structure does not exhibit a pattern of crystallographic defects extending from the inner spacers; at operation 1316, the process includes forming a gate structure between the first suspended channel and the second suspended channel, the gate structure extending to the inner spacers.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Although an overview of embodiments has been described with reference to specific example embodiments, various modifications and changes may be made to these embodiments without departing from the broader scope of embodiments of the present disclosure. Such embodiments of the inventive subject matter may be referred to herein, individually or collectively, by the term "invention" merely for convenience and without intending to voluntarily limit the scope of this application to any single disclosure or inventive concept if more than one is, in fact, disclosed.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

It will also be understood that, although the terms "first," "second," and so forth may be used herein to describe various elements, these elements should not be limited by these terms. These terms are only used to distinguish one element from another. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

In embodiments, the phrase "A is located on B" means that at least a part of A is in direct physical contact or indirect physical contact (having one or more other features between A and B) with at least a part of B.

In the instant description, "A is adjacent to B" means that at least part of A is in direct physical contact with at least a part of B.

In the instant description, "B is between A and C" means that at least part of B is in or along a space separating A and C and that the at least part of B is in direct or indirect physical contact with A and C.

In the instant description, "A is attached to B" means that at least part of A is mechanically attached to at least part of B, either directly or indirectly (having one or more other features between A and B).

The use of "source/drain" or "S/D" herein is simply intended to refer to just a source region, just a drain region or both a source region and a drain region. To this end, the forward slash ("/") as used herein means "and/or" unless otherwise specified, and is not intended to implicate any particular structural limitation or arrangement with respect to source and drain regions, or any other materials or features that are listed herein in conjunction with a forward slash.

The use of the techniques and structures provided herein can be detected using tools such as: electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools can indicate an integrated circuit including at least one gate-all-around (GAA) transistors as described herein.

In some embodiments, the techniques, processes and/or methods described herein can be detected based on the structures formed therefrom. In addition, in some embodiments, the techniques and structures described herein can be detected based on the benefits derived therefrom, such as the improved channel characteristics in pMOS GAA transistor structures. Numerous configurations and variations will be apparent in light of this disclosure.

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," "according to some embodiments," "in accordance with embodiments," or "in embodiments," which may each refer to one or more of the same or different embodiments. Furthermore, the terms "comprising," "including," "having," and the like, as used with respect to embodiments of the present disclosure, are synonymous.

"Coupled" as used herein means that two or more elements are in direct physical contact, or that that two or more elements indirectly physically contact each other, but yet still cooperate or interact with each other (i.e. one or more other elements are coupled or connected between the elements that are said to be coupled with each other). The term "directly coupled" means that two or more elements are in direct contact.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn and Ni.

As used herein, an "integrated circuit structure" may include one or more microelectronic dies.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices. The term "signal" may refer to at least one current signal, voltage signal, magnetic signal, or data/clock signal. The meaning of "a," "an," and "the" include plural references. The meaning of "in" includes "in" and "on."

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors--BJT PNP/NPN, BiCMOS, CMOS, eFET, etc., may be used without departing from the scope of the disclosure. The term "MN" indicates an n-type transistor (e.g., nMOS, NPN BJT, etc.) and the term "MP" indicates a p-type transistor (e.g., pMOS, PNP BJT, etc.).

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

### Examples

Some non-limiting example embodiments are set forth below.

Example 1 includes an integrated circuit (IC) device including: a substrate; a transistor device on the substrate, the transistor device including: a multilayer stack including: a plurality of channel layers on the substrate, the channel layers including a semiconductor material; a gate structure wrapped at least partially around the channel layers, the gate structure including a metal; an epitaxial source structure at a first lateral end of the multilayer stack; an epitaxial drain structure at a second lateral end of the multilayer stack opposite the first lateral end; and inner spacers between the gate structure and respective ones of the source structure and the drain structure, wherein at least one of the source structure or the drain structure does not exhibit a pattern of crystallographic defects extending from the inner spacers.

Example 2 includes the subject matter of Example 1, further including an array of transistor devices including the transistor device, wherein the transistor device is a first transistor device, and wherein individual ones of at least some of the transistor devices of the array have an identical structure to a structure of the first transistor.

Example 3 includes the subject matter of Example 2, wherein the transistor devices include gate all-around (GAA) transistor devices.

Example 4 includes the subject matter of Example 1, wherein an integrated average of strains in the channel layers yields a total compressive strain.

Example 5 includes the subject matter of Example 1, wherein the inner spacers define concavities facing away from one of the source structure or the drain structure, the gate structure extending into the concavities.

Example 6 includes the subject matter of Example 1, wherein the inner spacers define respective substantially flat surfaces facing away from one of the source structure or the drain structure and adjacent the gate structure.

Example 7 includes the subject matter of Example 1, wherein the inner spacers include silicon, oxygen and carbon.

Example 8 includes the subject matter of Example 5, wherein a ratio of carbon to oxygen is between about 1:3 to about 10:1.

Example 9 includes the subject matter of Example 1, wherein the inner spacers comprise silicon, carbon, oxygen and nitrogen, wherein an atomic percent of carbon is between 3-5 percent, an atomic percent of oxygen is between 25-40 percent, and an atomic percent of nitrogen is between 10-20 percent.

Example 10 includes the subject matter of Example 1, wherein the inner spacers include halogen.

Example 11 includes the subject matter of Example 1, wherein the channel layers include at least one of germanium, silicon, tin, indium, gallium, aluminum, arsenic, phosphorous, antimony, or bismuth.

Example 12 includes the subject matter of Example 8, wherein the source structure and the drain structure include at least one of germanium, silicon, tin, indium, gallium, aluminum, arsenic, phosphorous, antimony, or bismuth.

Example 13 includes the subject matter of Example 1, wherein the gate structure includes a gate electrode including the metal, and a gate dielectric layer between the gate electrode and the channel layers.

Example 14 includes the subject matter of Example 13, wherein the gate dielectric includes a high-k dielectric material.

Example 15 includes the subject matter of Example 1, wherein the channel layers define one of nanowires, nanoribbons or nanosheets.

Example 16 includes the subject matter of Example 1, wherein the source structure and the drain structure include a positive epitaxial material (p-EPI).

Example 17 includes an integrated circuit (IC) device structure comprising: a substrate; an IC device including an array of transistor devices on the substrate, individual ones of at least some of the transistor devices of the array including: a multilayer stack including: a plurality of channel layers on the substrate, the channel layers including a semiconductor material; a gate structure wrapped at least partially around the channel layers, the gate structure including a metal; an epitaxial source structure at a first lateral end of the multilayer stack; an epitaxial drain structure at a second lateral end of the multilayer stack opposite the first lateral end; and inner spacers between the gate structure and respective ones of the source structure and the drain structure, wherein at least one of the source structure or the drain structure does not exhibit a pattern of crystallographic defects extending from the inner spacers; and conductive structures electrically coupling corresponding ones of the transistor devices to each other, the conductive structures including metal interconnects and contacts coupled to corresponding ones of the transistor devices.

Example 18 includes the subject matter of Example 17, wherein the transistor devices include gate all-around (GAA) transistor devices.

Example 19 includes the subject matter of Example 17, wherein an integrated average of strains in the channel layers yields a total compressive strain.

Example 20 includes the subject matter of Example 17, wherein the inner spacers define concavities facing away from one of the source structure or the drain structure, the gate structure extending into the concavities.

Example 21 includes the subject matter of Example 17, wherein the inner spacers define respective substantially flat surfaces facing away from one of the source structure or the drain structure and adjacent the gate structure.

Example 22 includes the subject matter of Example 17, wherein the inner spacers include silicon, oxygen and carbon.

Example 23 includes the subject matter of Example 21, wherein a ratio of carbon to oxygen is between about 1:3 to about 10:1.

Example 24 includes the subject matter of Example 17, wherein the inner spacers comprise silicon, carbon, oxygen and nitrogen, wherein an atomic percent of carbon is between 3-5 percent, an atomic percent of oxygen is between 25-40 percent, and an atomic percent of nitrogen is between 10-20 percent.

Example 25 includes the subject matter of Example 17, wherein the inner spacers include halogen.

Example 26 includes the subject matter of Example 17, wherein the channel layers include at least one of germanium, silicon, tin, indium, gallium, aluminum, arsenic, phosphorous, antimony, or bismuth.

Example 27 includes the subject matter of Example 24, wherein the source structure and the drain structure include at least one of germanium, silicon, tin, indium, gallium, aluminum, arsenic, phosphorous, antimony, or bismuth.

Example 28 includes the subject matter of Example 17, wherein the gate structure includes a gate electrode including the metal, and a gate dielectric layer between the gate electrode and the channel layers.

Example 29 includes the subject matter of Example 28, wherein the gate dielectric includes a high-k dielectric material.

Example 30 includes the subject matter of Example 17, wherein the channel layers define one of nanowires, nanoribbons or nanosheets.

Example 31 includes the subject matter of Example 17, wherein the source structure and the drain structure include a positive epitaxial material (p-EPI).

Example 32 includes an integrated circuit (IC) device assembly including: a printed circuit board; and a plurality of integrated circuit components attached to the printed circuit board, individual ones of the integrated circuit components including one or more integrated circuit dies, individual ones of the dies including: a plurality of gate all-around (GAA) transistor devices, wherein individual ones of the plurality of GAA transistor devices include: a multilayer stack including: a plurality of channel layers including a semiconductor material; a gate structure wrapped at least partially around the channel layers, the gate structure including a metal; an epitaxial source structure at a first lateral end of the multilayer stack; an epitaxial drain structure at a second lateral end of the multilayer stack opposite the first lateral end; and inner spacers between the gate structure and respective ones of the source structure and the drain structure, wherein at least one of the source structure or the drain structure does not exhibit a pattern of crystallographic defects extending from the inner spacers; and conductive structures electrically coupling corresponding ones of the transistor devices to each other, the conductive structures including metal interconnects and contacts coupled to corresponding ones of the gate structure, the source structure and the drain structure of .

Example 33 includes the subject matter of Example 32, wherein the transistor devices include gate all-around (GAA) transistor devices.

Example 34 includes the subject matter of Example 32, wherein an integrated average of strains in the channel layers yields a total compressive strain.

Example 35 includes the subject matter of Example 32, wherein the inner spacers define concavities facing away from one of the source structure or the drain structure, the gate structure extending into the concavities.

Example 36 includes the subject matter of Example 32, wherein the inner spacers define respective substantially flat surfaces facing away from one of the source structure or the drain structure and adjacent the gate structure.

Example 37 includes the subject matter of Example 32, wherein the inner spacers include silicon, oxygen and carbon.

Example 38 includes the subject matter of Example 36, wherein a ratio of carbon to oxygen is between about 1:3 to about 10:1.

Example 39 includes the subject matter of Example 32, wherein the inner spacers comprise silicon, carbon, oxygen and nitrogen, wherein an atomic percent of carbon is between 3-5 percent, an atomic percent of oxygen is between 25-40 percent, and an atomic percent of nitrogen is between 10-20 percent.

Example 40 includes the subject matter of Example 32, wherein the inner spacers include halogen.

Example 41 includes the subject matter of Example 32, wherein the channel layers include at least one of germanium, silicon, tin, indium, gallium, aluminum, arsenic, phosphorous, antimony, or bismuth.

Example 42 includes the subject matter of Example 39, wherein the source structure and the drain structure include at least one of germanium, silicon, tin, indium, gallium, aluminum, arsenic, phosphorous, antimony, or bismuth.

Example 43 includes the subject matter of Example 32, wherein the gate structure includes a gate electrode including the metal, and a gate dielectric layer between the gate electrode and the channel layers.

Example 44 includes the subject matter of Example 43, wherein the gate dielectric includes a high-k dielectric material.

Example 45 includes the subject matter of Example 32, wherein the channel layers define one of nanowires, nanoribbons or nanosheets.

Example 46 includes the subject matter of Example 32, wherein the source structure and the drain structure include a positive epitaxial material (p-EPI).

Example 47 includes a method of fabricating a transistor device, the method comprising: forming a material layer stack on a substrate, the material layer stack comprising plurality of bilayers, wherein individual ones of the bilayers are formed by depositing a channel layer on a layer of sacrificial material; patterning the material layer stack into a fin, the fin including a plurality of channel layers; forming a dummy gate over a first portion of the fin; growing an epitaxial source structure adjacent to a first end of the fin and an epitaxial drain structure adjacent to a second end of the fin, wherein the first end of the fin and the second end of the fin have respective continuous epitaxial surfaces for growing corresponding ones of the source structure and the drain structure thereon; etching and removing the dummy gate; removing the sacrificial material from the fin to form a first suspended channel over a second suspended channel; after growing the source structure and the drain structure and after removing the sacrificial material from the fin, growing inner spacers in respective cavities between the first suspended channel and the second suspended channel, the inner spacers adjacent respective ones of the source structure and the drain structure, wherein at least one of the source structure or the drain structure does not exhibit a pattern of crystallographic defects extending from the inner spacers; and forming a gate structure between the first suspended channel and the second suspended channel, the gate structure extending to the inner spacers.

Example 48 includes the subject matter of Example 47, wherein growing the inner spacers comprises selectively growing the inner spacers from corresponding surfaces of the source structure and of the drain structure.

Example 49 includes the subject matter of Example 48, wherein selectively growing the inner spacers includes using a precursor including halogen.

Example 50 includes the subject matter of Example 47, wherein the transistor device includes a gate all-around (GAA) transistor devices.

Example 51 includes the subject matter of Example 47, wherein an integrated average of strains in the channel layers yields a total compressive strain.

Example 52 includes the subject matter of Example 47, wherein the inner spacers define concavities facing away from one of the source structure or the drain structure, the gate structure extending into the concavities.

Example 53 includes the subject matter of Example 47, wherein the inner spacers define respective substantially flat surfaces facing away from one of the source structure or the drain structure and adjacent the gate structure.

Example 54 includes the subject matter of Example 47, wherein the inner spacers include silicon, oxygen and carbon.

Example 55 includes the subject matter of Example 54, wherein a ratio of carbon to oxygen is between about 1:3 to about 10:1.

Example 56 includes the subject matter of Example 47, wherein the inner spacers comprise silicon, carbon, oxygen and nitrogen, wherein an atomic percent of carbon is between 3-5 percent, an atomic percent of oxygen is between 25-40 percent, and an atomic percent of nitrogen is between 10-20 percent.

Example 57 includes the subject matter of Example 47, wherein the inner spacers include halogen.

Example 58 includes the subject matter of Example 47, wherein the channel layers include at least one of germanium, silicon, tin, indium, gallium, aluminum, arsenic, phosphorous, antimony, or bismuth.

Example 59 includes the subject matter of Example 58, wherein the source structure and the drain structure include at least one of germanium, silicon, tin, indium, gallium, aluminum, arsenic, phosphorous, antimony, or bismuth.

Example 60 includes the subject matter of Example 47, wherein the gate structure includes a gate electrode including a metal, and a gate dielectric layer between the gate electrode and the channel layers.

Example 61 includes the subject matter of Example 60, wherein the gate dielectric includes a high-k dielectric material.

Example 62 includes the subject matter of Example 47, wherein the channel layers define one of nanowires, nanoribbons or nanosheets.

Example 63 includes the subject matter of Example 47, wherein the source structure and the drain structure include a positive epitaxial material (p-EPI).

## Claims

1. An integrated circuit (IC) device including:
a substrate;
a transistor device on the substrate, the transistor device including:
a multilayer stack comprising:
a plurality of channel layers on the substrate, the channel layers including a semiconductor material;
a gate structure wrapped at least partially around the channel layers, the gate structure including a metal;
an epitaxial source structure at a first lateral end of the multilayer stack;
an epitaxial drain structure at a second lateral end of the multilayer stack opposite the first lateral end; and
inner spacers between the gate structure and respective ones of the source structure and the drain structure, wherein at least one of the source structure or the drain structure does not exhibit a pattern of crystallographic defects extending from the inner spacers.

2. The IC device of claim 1, wherein the transistor device includes a gate all-around (GAA) transistor device.

3. The IC device of claim 1, wherein an integrated average of strains in the channel layers yields a total compressive strain.

4. The IC device of any one of claims 1-3, wherein the inner spacers define concavities facing away from one of the source structure or the drain structure, the gate structure extending into the concavities.

5. The IC device of any one of claims 1-4, wherein the inner spacers comprise silicon, carbon, oxygen and nitrogen, an atomic percent of carbon is between 3-5 percent, an atomic percent of oxygen is between 25-40 percent, and an atomic percent of nitrogen is between 10-20 percent.

6. The IC device of any one of claims 1-5, wherein the inner spacers include halogen.

7. The IC device of claim 1, wherein the channel layers, the source structure and the drain structure include at least one of germanium, silicon, tin, indium, gallium, aluminum, arsenic, phosphorous, antimony, or bismuth.

8. The IC device of claim 1, wherein the gate structure includes a gate electrode including the metal, and a high-k gate dielectric layer between the gate electrode and the channel layers.

9. The IC device of claim 1, wherein the source structure and the drain structure include a positive epitaxial material (p-EPI).

10. An integrated circuit (IC) device structure comprising:
a substrate;
an IC device including an array of transistor devices on the substrate, individual ones of at least some of the transistor devices of the array including:
a multilayer stack including:
a plurality of channel layers on the substrate, the channel layers including a semiconductor material;
a gate structure wrapped at least partially around the channel layers, the gate structure including a metal;
an epitaxial source structure at a first lateral end of the multilayer stack;
an epitaxial drain structure at a second lateral end of the multilayer stack opposite the first lateral end; and
inner spacers between the gate structure and respective ones of the source structure and the drain structure, wherein an integrated average of strains in the channel layers yields a total compressive strain; and
conductive structures electrically coupling corresponding ones of the transistor devices to each other, the conductive structures including metal interconnects and contacts coupled to corresponding ones of the transistor devices.

11. The IC device structure of claim 10, wherein the transistor devices include gate all-around (GAA) transistor devices.

12. An integrated circuit (IC) device assembly including:
a printed circuit board; and
a plurality of integrated circuit components attached to the printed circuit board, individual ones of the integrated circuit components including one or more integrated circuit dies, individual ones of the dies including:
a plurality of gate all-around (GAA) transistor devices, wherein individual ones of the plurality of GAA transistor devices include:
a multilayer stack including:
a plurality of channel layers including a semiconductor material;
a gate structure wrapped at least partially around the channel layers, the gate structure including a metal;
an epitaxial source structure at a first lateral end of the multilayer stack;
an epitaxial drain structure at a second lateral end of the multilayer stack opposite the first lateral end; and
inner spacers between the gate structure and respective ones of the source structure and the drain structure, wherein at least one of the source structure or the drain structure does not exhibit a pattern of crystallographic defects extending from the inner spacers; and
conductive structures electrically coupling corresponding ones of the transistor devices to each other, the conductive structures including metal interconnects and contacts coupled to corresponding ones of the gate structure, the source structure and the drain structure of .

13. The IC device assembly of claim 12, wherein an integrated average of strains in the channel layers yields a total compressive strain.

14. A method of fabricating a transistor device, the method comprising:
forming a material layer stack on a substrate, the material layer stack comprising plurality of bilayers, wherein individual ones of the bilayers are formed by depositing a channel layer on a layer of sacrificial material;
patterning the material layer stack into a fin, the fin including a plurality of channel layers;
forming a dummy gate over a first portion of the fin;
growing an epitaxial source structure adjacent to a first end of the fin and an epitaxial drain structure adjacent to a second end of the fin, wherein the first end of the fin and the second end of the fin have respective continuous epitaxial surfaces for growing corresponding ones of the source structure and the drain structure thereon;
etching and removing the dummy gate;
removing the sacrificial material from the fin to form a first suspended channel over a second suspended channel;
after growing the source structure and the drain structure and after removing the sacrificial material from the fin, growing inner spacers in respective cavities between the first suspended channel and the second suspended channel, the inner spacers adjacent respective ones of the source structure and the drain structure, wherein at least one of the source structure or the drain structure does not exhibit a pattern of crystallographic defects extending from the inner spacers; and
forming a gate structure between the first suspended channel and the second suspended channel, the gate structure extending to the inner spacers.

15. The method of claim 14, wherein growing the inner spacers comprises selectively growing the inner spacers from corresponding surfaces of the source structure and of the drain structure, and wherein selectively growing the inner spacers includes using a precursor including halogen.
